(19) Europäisches Patentamt / European Patent Office / Office européen des brevets

(11) **EP 2 141 185 A1**

(12) **EUROPEAN PATENT APPLICATION**
published in accordance with Art. 153(4) EPC

(43) Date of publication:
06.01.2010 Bulletin 2010/01

(51) Int Cl.:
*C08G 18/42* (2006.01)    *B29C 45/02* (2006.01)
*B29C 45/14* (2006.01)    *C08G 18/10* (2006.01)
*C08K 5/13* (2006.01)    *C08L 75/04* (2006.01)
*H01L 33/00* (2010.01)    *B29K 101/10* (2006.01)

(21) Application number: 08751978.1

(22) Date of filing: 23.04.2008

(86) International application number:
PCT/JP2008/057840

(87) International publication number:
WO 2008/133271 (06.11.2008 Gazette 2008/45)

(84) Designated Contracting States:
AT BE BG CH CY CZ DE DK EE ES FI FR GB GR
HR HU IE IS IT LI LT LU LV MC MT NL NO PL PT
RO SE SI SK TR

(30) Priority: 24.04.2007 JP 2007114148
24.04.2007 JP 2007114149
30.10.2007 JP 2007282031

(71) Applicant: Hitachi Chemical Company, Ltd.
Tokyo 163-0449 (JP)

(72) Inventors:
• TOMIYAMA, Takeo
Tsukuba-shi
Ibaraki 300-4247 (JP)
• TANAKA, Shouko
Tsukuba-shi
Ibaraki 300-4247 (JP)
• YOSHIDA, Akihiro
Tsukuba-shi
Ibaraki 300-4247 (JP)
• KOBAYASHI, Shingo
Tsukuba-shi
Ibaraki 300-4247 (JP)

(74) Representative: Jönsson, Hans-Peter
Patentanwälte von Kreisler Selting Werner
Deichmannhaus am Dom
Bahnhofsvorplatz 1
50667 Köln (DE)

(54) **CURABLE RESIN COMPOSITION, LED PACKAGE, AND METHOD FOR PRODUCTION OF THE LED PACKAGE, AND OPTICAL SEMICONDUCTOR**

(57) The curable resin composition of the present invention comprises a polyol component containing tri- or higher functional polycaprolactone polyol; and a polyisocyanate component containing bifunctional or trifunctional alicyclic isocyanate having one or more chemical structures in which an isocyanate group is bonded to a secondary carbon atom.

## Fig.1

**Description**

**Technical Field**

The present invention relates to a curable resin composition, a light emitting diode (LED) package, and a method for production of the light emitting diode package. Also, the present invention relates to a curable resin composition a cured product of which has high optical transparency, excellent optical properties, such as heat and light discoloration resistance, and excellent mechanical properties, and an optical semiconductor, such as a light emitting diode (LED), a phototransistor, a photodiode, and a solid-state image pickup device, using the cured product and having excellent reliability.

**Background Art**

Conventionally, an acrylic resin having excellent transparency and light resistance has been generally frequently used as a resin for an optical member. Also, an epoxy resin has been generally used as a resin for an optical member used in the field of optical and electronic equipment because the resin is required to have heat resistance and mechanical properties in the process of mounting on an electronic substrate and the like and under high temperature operation.
In recent years, the use of high-intensity laser light, blue light, and near-ultraviolet light has been spread also in applications in the field of optical and electronic equipment, and with this, a resin having more excellent transparency, heat resistance, light resistance, and the like than conventional ones is required. However, although epoxy resins have high transparency in the visible light region, they do not have sufficiently high transparency in the ultraviolet to near-ultraviolet light region. Among them, an epoxy resin using alicyclic bisphenol A diglycidyl ether and the like has relatively high transparency, but has problems, such as being easily discolored by heat and light.
Accordingly, for example, Patent Documents 1 and 2 disclose a method for reducing impurities included in alicyclic bisphenol A diglycidyl ether, which are one of the causes of discoloration.
However, while a further improvement in heat resistance and discoloration resistance to ultraviolet rays will be required in the future, it cannot be said to be sufficient yet with the means described in the above Patent Documents 1 and 2.
Also, as a resin system a cured product of which has excellent transparency in the near-ultraviolet region, one obtained from an alicyclic epoxy resin and acid anhydride is known. However, this cured product has poorer breaking strength and toughness than that of an aromatic epoxy resin, and therefore, interface debonding between the cured product and a different type of bonded material and cracks in the molded product are not sufficient. Also, another problem of this resin system is that the acid anhydride volatilizes during curing, and the volume is decreased.
On the other hand, an acrylic resin has high transparency and has excellent discoloration resistance in which it is not easily discolored even by light or heat, but mechanical properties, such as breaking strength, cannot be said to be sufficient, and a further improvement in properties is required. Also, in this resin system, the cure shrinkage is relatively large, and the decrease in volume during curing is significant.
On the other hand, a silicone resin has high transparency up to the near-ultraviolet region and has high Si-O bond energy, and therefore, it has the characteristics of having excellent light resistance and not being easily discolored by heat or light. Generally, a silicone resin is polymerized by dehydration condensation reaction between silanol groups, condensation reaction between a silanol group and a hydrolyzable group, reaction between a methylsilyl group and a vinylsilyl group with organic peroxide, addition reaction between a vinylsilyl group and a hydrosilyl group, or the like.
For example, Patent Document 3 discloses a silicone resin obtained by addition reaction between a vinylsilyl group and a hydrosilyl group.
However, the problems of the silicone resin obtained using addition reaction between a vinylsilyl group and a hydrosilyl group, described in the above Patent Document 3, are that curing may not proceed due to the effect of a catalyst poison in the curing atmosphere, the thermal expansion coefficient of the cured product is high, and the like.
On the other hand, a urethane resin obtained by reaction between an isocyanate group and a hydroxyl group, particularly, a urethane resin using alicyclic isocyanate, has excellent heat and light discoloration resistance, and therefore, it is used as a resin for molding an optical lens, as shown in Patent Document 4. Also, Patent Document 5 discloses an example of a urethane resin composition for a photoelectric conversion device-sealing material, using aliphatic or alicyclic polyisocyanate.
Patent Document 1: Japanese Patent Laid-Open No. 2003-171439
Patent Document 2: Japanese Patent Laid-Open No. 2004-075894
Patent Document 3: Japanese Patent Laid-Open No. 2004-186168
Patent Document 4: Japanese Patent Laid-Open No. 2003-301025
Patent Document 5: Japanese Patent Laid-Open No. 2001-278941

**Disclosure of the Invention**

Problems to be Solved by the Invention

A resin composition, preferred for an optical member, that is a solvent-free resin composition and is liquid at room temperature, a cured product of which has small cure shrinkage and has excellent optical properties, such as transparency, light resistance, and heat resistance, and excellent mechanical properties, such as breaking strength, is desired as a resin composition for an optical member.

A sealing resin for an LED requires particularly excellent transparency, light resistance, and heat resistance to suppress a decrease in the luminance of the LED. There are a temperature cycle test and a high-temperature and high-humidity lighting test for evaluating the reliability of an LED package, and high mechanical properties and high-temperature and high-humidity resistance are also required to pass these tests.

However, for example, in a case where a urethane resin using polyisocyanate in which an isocyanate group is adjacent to primary carbon, as shown in Examples in Patent Document 5, is used for the sealing of an LED, there is a problem that a decrease in luminance occurs when a continuous lighting test under high-temperature and high-humidity conditions is performed, as shown in Comparative Example 4 in the present invention.

Cast molding in which a resin is cast into a mold, and heated and cured is generally used as a method for sealing an LED using a liquid thermosetting resin. However, a problem of this method is that the curing of the thermosetting resin is slow, and therefore, the productivity is poor. Also, it is difficult to control the thickness of the sealing resin, and voids are easily trapped in the sealing resin.

In recent years, with the expansion of the LED market, an LED package making process that improves mass productivity has been required. From such a viewpoint, liquid transfer molding, which is a molding method in which a resin composition that is liquid at room temperature is injected into the cavity of a heated die, and heated and cured, and compression molding are useful because of short molding time and high productivity. Also, with these molding methods, the sealing resin can have any shape. In order to make an LED package by applying such liquid transfer molding, a resin composition having curing speed suited to the molding conditions is necessary.

The present invention has been made in view of the above circumstances. It is a first object of the present invention to provide a curable resin composition that can form a cured product particularly having sufficiently excellent high-temperature and high-humidity resistance, an LED package made using the resin composition, and a method for production of the LED package.

Further, generally, a urethane resin has low glass transition temperature, and therefore, there is a problem that the wire displacement is large in a temperature cycle test, thus, the breaking of the wire occurs, as shown in Comparative Examples 4 to 8 described later. Therefore, there is a demand for a resin composition that is solvent-free and is liquid at room temperature (25°C), a cured product of which has excellent optical properties, such as transparency and light and heat discoloration resistance, and excellent mechanical properties, and that further provides excellent reliability when used for the sealing of an optical semiconductor device.

The present invention has been made in view of the above circumstances. It is a second object of the present invention to provide a curable resin composition a cured product of which has high transparency, excellent optical properties, such as heat and light discoloration resistance, and excellent mechanical properties, and an optical semiconductor, such as a light emitting diode (LED), a phototransistor, a photodiode, and a solid-state image pickup device, using the cured product and having excellent reliability.

Means for Solving the Problems

In order to achieve the above first object, the present invention provides the following first curable resin composition, LED package, and method for production of the LED package.

The present invention provides a curable resin composition comprising: a polyol component containing tri- or higher functional polycaprolactone polyol; and a polyisocyanate component containing 40% by mass or more of bifunctional or trifunctional alicyclic isocyanate having one or more chemical structures in which an isocyanate group is bonded to a secondary carbon atom.

Also, the present invention provides a curable resin composition comprising: a polyol component containing 40% by mass or more of tri- or higher functional polycaprolactone polyol having a weight-average molecular weight of 800 or less and a hydroxyl group value of 200 mgKOH/g or more; and a polyisocyanate component containing bifunctional or trifunctional alicyclic isocyanate having one or more chemical structures in which an isocyanate group is bonded to a secondary carbon atom.

In the curable resin composition of the present invention comprising the above-described configuration, the decrease in luminance is sufficiently suppressed even if a light emitting diode made using this resin composition is exposed to high-temperature and high-humidity conditions. The factors that enable the formation of a cured product particularly having sufficiently excellent high-temperature and high-humidity resistance in this manner are not presently clear in detail. However, the present inventors consider a factor described below, as one of the factors. However, the factors are not limited to this.

In other words, the curable resin composition contains bifunctional or trifunctional alicyclic isocyanate having one or more chemical structures in which an isocyanate group is bonded to a secondary carbon atom, as the polyisocyanate component, in addition to the polyol component containing tri- or higher functional polycaprolactone polyol having three or more hydroxyl groups in one molecule, thereby, the high-temperature and high-humidity resistance of the cured product is sufficiently improved, compared with a case where the curable resin composition contains alicyclic polyisocyanate not having such a chemical structure. Further, by containing 40% by mass or more of such alicyclic isocyanate in the whole polyisocyanate component, the high-temperature and high-humidity resistance of the cured product is more sufficiently high. Similarly, even by containing 40% by mass or more of tri- or higher functional polycaprolactone polyol having a weight-average molecular weight of 800 or less and a hydroxyl group value of 200 mgKOH/g or more in the whole polyol component, the high-temperature and high-humidity resistance of the cured product is more sufficiently high.

Also, the cured product of the curable resin composition of the present invention has high transparency, and moreover, its curing speed can be adjusted to that suited to liquid transfer molding. Therefore, this curable resin composition is useful for making a light emitting diode package by liquid transfer molding, and its cured product is sufficiently suitable as a transparent sealing resin for a light emitting diode.

In the curable resin composition of the present invention, the gelation time at 165°C is preferably 10 to 200 seconds. Thus, a light emitting diode package can be made by liquid transfer molding under substantially the same molding conditions as those of conventional solid transfer molding (molding in which a raw material that is solid at room temperature is melted in a pot, and then the melted raw material is injected into the cavity of a die and cured), and therefore, the efficiency of making a package is improved.

Here, the "gelation time" in the present invention is measured using a commercially available gelation tester. In more detail, 0.2 g of the curable resin composition is placed on a hot plate heated to 165°C, and the gelation time is measured by hand curing.

In the curable resin composition of the present invention, the polyol component preferably contains a prepolymer having a residual hydroxyl group obtained by reacting polyol and bi- or higher functional isocyanate having a total number of isocyanate groups smaller than the total number of hydroxyl groups of the polyol. The polyol component contains such a prepolymer, thereby, the curing speed of the curable resin composition is faster and is more suitable for liquid transfer molding. Also, by containing such a prepolymer, the compatibility of the polyol component and the polyisocyanate component is further improved. Further, it is also possible to contribute to a reduction in the cure shrinkage of the curable resin composition.

From a similar viewpoint, the polyisocyanate component preferably contains a prepolymer having a residual isocyanate group obtained by reacting bi- or higher functional isocyanate and polyol having a total number of hydroxyl groups smaller than the total number of isocyanate groups of the isocyanate.

The curable resin composition of the present invention preferably contains a hindered phenolic antioxidant in terms of increasing light resistance.

The present invention provides a light emitting diode package comprising a sealing member obtained by curing and molding the above curable resin composition. This light emitting diode package uses the cured product of the curable resin composition of the present invention as the sealing member, and the high-temperature and high-humidity resistance of the sealing member is sufficiently excellent. Therefore, high luminance can be maintained for a long time in a high-temperature and high-humidity lighting test. Such a light emitting diode package can be made by a production method comprising the step of curing and molding the above-described curable resin composition by liquid transfer molding to obtain a sealing member. According to this production method, the above-described light emitting diode package can be produced with high productivity.

In order to achieve the above second object, the present invention provides the following second curable resin composition and optical semiconductor.

The present invention provides a curable resin composition comprising: a polyol component; and a polyisocyanate component containing bi- or higher functional isocyanurate type isocyanate having one or more chemical structures in which an isocyanate group is bonded to a secondary carbon atom, wherein a cured product of the curable resin composition has a glass transition temperature of 110°C or more, a thermal expansion coefficient of $10.0 \times 10^{-5}/°C$ or less at the glass transition temperature or lower, a thermal expansion coefficient of $20.0 \times 10^{-5}/°C$ or less at the glass transition temperature or higher, and a flexural modulus of 1500 MPa or more at 25°C.

In the curable resin composition of the present invention, the above polyol component preferably contains 40% by mass or more of tri- or higher functional polycaprolactone polyol having a weight-average molecular weight of 500 or less and a hydroxyl group value of 300 mgKOH/g or more, and 30% by mass or more of tri- or higher functional aliphatic polyol having a weight-average molecular weight of 350 or less and a hydroxyl group value of 500 mgKOH/g or more, and the above polyisocyanate component preferably contains 40% by mass or more of the above isocyanurate type isocyanate.

Here, the above aliphatic polyol is preferably trimethylolpropane or a derivative thereof.

In the curable resin composition of the present invention, the above isocyanurate type isocyanate is preferably a trimer of isophorone diisocyanate.

In the curable resin composition of the present invention, the above polyol component preferably contains a prepolymer having a residual hydroxyl group obtained by reacting polyol and bi- or higher functional isocyanate having a total number of isocyanate groups smaller than the total number of hydroxyl groups of the polyol.

Here, the above prepolymer in the above polyol component is preferably obtained by reacting the above polyol and the above isocyanate at a ratio of a hydroxyl group equivalent X in the above polyol to an isocyanate group equivalent Y in the above isocyanate (X/Y) of 3 or more.

In the curable resin composition of the present invention, the above polyisocyanate component preferably contains a prepolymer having a residual isocyanate group obtained by reacting bi- or higher functional isocyanate and polyol having a total number of hydroxyl groups smaller than the total number of isocyanate groups of the isocyanate.

Here, the above polyol is preferably tri- or higher functional aliphatic polyol having a weight-average molecular weight of 350 or less and a hydroxyl group value of 500 mgKOH/g or more.

Also, the above prepolymer in the above polyisocyanate component is preferably obtained by reacting the above polyol and the above isocyanate at a ratio of the hydroxyl group equivalent X in the above polyol to the isocyanate group equivalent Y in the above isocyanate (X/Y) of 0.05 to 0.30.

The curable resin composition of the present invention preferably contains a hindered phenolic antioxidant.

Here, the above hindered phenolic antioxidant is preferably 3,9-bis[2-{3-(3-t-butyl-4-hydroxy-5-methylphenyl) propionyl}-1,1-dime thylethyl]-2,4,8,10-tetraoxaspiro[5,5]undecane.

In the curable resin composition of the present invention, gelation time at 165°C is preferably 10 to 200 seconds.

The curable resin composition of the present invention preferably contains the above polyol component and the above polyisocyanate component so that the ratio of a hydroxyl group equivalent in the above polyol component to an isocyanate group equivalent in the above polyisocyanate component (hydroxyl group equivalent/isocyanate group equivalent) is 0.7 to 1.3.

The present invention further provides an optical semiconductor comprising a member obtained by molding the above curable resin composition of the present invention by liquid transfer molding.

**Effect of the Invention**

The present invention can provide a first curable resin composition that can form a cured product particularly having sufficiently excellent high-temperature and high-humidity resistance, an LED package made using the resin composition, and a method for production of the LED package. Also, the second curable resin composition of the present invention has characteristics that its cured product has high transparency, excellent optical properties, such as heat and light discoloration resistance, and excellent mechanical properties, and simultaneously has high glass transition temperature and a low thermal expansion coefficient. Therefore, when the curable resin composition is used as a sealing resin for an optical semiconductor device, the breaking of the wire does not occur easily in a temperature cycle test, and the life and reliability of the optical semiconductor device can be improved.

**Brief Description of the Drawings**

Figure 1 is a schematic cross-sectional view showing a light emitting diode package according to a preferred embodiment of the present invention; and

Figure 2 is a schematic cross-sectional view showing a light emitting diode package according to another embodiment of the present invention.

Description of Symbols

1: board, 2: wiring layer, 22: lead frame, 3 and 23: adhesive member, 4 and 24: light emitting diode device, 5 and 25: wire, 6 and 26: sealing member, 10 and 20: light emitting diode package, 27: case member.

**Best Modes for Carrying Out the Invention**

Preferred embodiments of the present invention will be described below in detail, with reference to the drawings as required. In the drawings, like numerals refer to like elements, and redundant description is omitted. Also, positional relationship, such as top, bottom, left, and right, is based on the positional relationship shown in the drawing, unless otherwise specified. Further, the dimensional ratio in the drawings is not limited to the ratio shown.

(First Curable Resin Composition)

First, the first curable resin composition of the present invention will be described. The first curable resin composition of the present invention comprises a polyol component containing tri- or higher functional polycaprolactone polyol, and a polyisocyanate component containing bifunctional or trifunctional alicyclic isocyanate having one or more chemical structures in which an isocyanate group is bonded to a secondary carbon atom (hereinafter referred to as "specific alicyclic isocyanate").

A curable resin composition according to a preferred first embodiment of the first curable resin composition comprises a polyol component containing tri- or higher functional polycaprolactone polyol, and a polyisocyanate component containing 40% by mass or more of specific alicyclic isocyanate.

A curable resin composition according to a preferred second embodiment comprises a polyol component containing 40% by mass or more of tri- or higher functional polycaprolactone polyol having a weight-average molecular weight of 800 or less and a hydroxyl group value of 200 mgKOH/g or more, and a polyisocyanate component containing specific alicyclic isocyanate.

The polyol component according to the present invention contains tri- or higher functional polycaprolactone polyol. Such polycaprolactone polyol includes trifunctional polycaprolactone polyol, that is, polycaprolactone triol, and tetrafunctional polycaprolactone polyol. The polyol component contains tri- or higher functional polycaprolactone polyol, thereby, the crosslinking density increases, achieving the effect that the hardness and toughness of the cured product increase.

The tri- or higher functional polycaprolactone polyol may be synthesized by an ordinary method, or a commercially available one may be obtained. The commercially available tri- or higher functional polycaprolactone polyol includes, for example, the trade name "PLACCEL" series manufactured by DAICEL CHEMICAL INDUSTRIES, LTD.

One tri- or higher functional polycaprolactone polyol is used alone, or two or more tri- or higher functional polycaprolactone polyols are used in combination.

In the second embodiment, the tri- or higher functional polycaprolactone polyol has a weight-average molecular weight of 800 or less and a hydroxyl group value of 200 mgKOH/g or more, thereby, the crosslinking density during curing increases sufficiently, and as a result, the hardness and toughness of the cured product is sufficiently high. In terms of further suppressing a decrease in the hardness and toughness of the cured product, the tri- or higher functional polycaprolactone polyol further preferably has a weight-average molecular weight of 500 or less and a hydroxyl group value of 300 mgKOH/g or more.

The polyol component preferably contains a prepolymer having a residual hydroxyl group obtained by reacting polyol and bi- or higher functional isocyanate having a total number of isocyanate groups smaller than the total number of the hydroxyl groups of the polyol. This prepolymer is obtained by the hydroxyl group of the polyol reacting with the isocyanate group of the isocyanate to produce a urethane bond. By containing this prepolymer, the curing speed of the curable resin composition is faster, and therefore, the composition is more suitable for liquid transfer molding. Also, the polyol component contains such a prepolymer, thereby, the compatibility of the polyol component and the polyisocyanate component is improved, and the degree of cure shrinkage is reduced. In this case, the polyol may be tri- or higher functional polycaprolactone polyol, or other polyols.

In synthesizing the above prepolymer, the ratio of the total number of the hydroxyl groups of the polyol, which is a raw material, (X) to the total number of the isocyanate groups of the isocyanate (Y) is preferably a ratio such that X/Y is 3 to 20. If X/Y is more than 20, the above-described effect obtained by using the prepolymer is reduced, and therefore, the advantage of using the prepolymer tends to be hardly obtained. If X/Y is less than 3, the molecular weight of the prepolymer increases. As a result, the viscosity increases, and therefore, the handling of the curable resin composition tends to be difficult.

Polyol included in the polyol component according to the present invention, other than the tri- or higher functional polycaprolactone polyol, includes, for example, polycaprolactone diol, ethylene glycol, 1,6-hexanediol, neopentyl glycol, trimethylolpropane, 1,4-dimethanol cyclohexane, polycarbonate diol, a hydroxyl group-containing acrylic resin having two or more hydroxyl groups in one molecule, and polyol having an isocyanurate skeleton. Among these, trimethylolpropane is preferred because the crosslinking density increases and the hardness of the cured product increases. One of these polyols is used alone, or two or more of these polyols are used in combination.

In the second embodiment, the content of the tri- or higher functional polycaprolactone polyol in the polyol component is 40% by mass or more, based on the total amount of the whole polyol component. Thus, the crosslinking density during curing increases sufficiently, and as a result, the hardness and toughness of the cured product is sufficiently high. In terms of more effectively achieving such an effect, the above content is more preferably 50% by mass or more.

6

When the polyol that is a raw material in synthesizing the above-described prepolymer is tri- or higher functional polycaprolactone polyol, the polycaprolactone polyol also applies to the above "tri- or higher functional polycaprolactone polyol in the polyol component."

In the first embodiment, the content of the specific alicyclic isocyanate in the polyisocyanate component is preferably 40% by mass or more, based on the total amount of the whole polyisocyanate component. Thus, the high-temperature and high-humidity resistance of the cured product of the curable resin composition is more sufficiently high. In terms of more effectively achieving such an effect and making the curing speed faster, the above content is more preferably 40 to 85% by mass. When the bi- or higher functional isocyanate that is a raw material in synthesizing the above-described prepolymer is specific alicyclic isocyanate, the alicyclic isocyanate also applies to the above "specific alicyclic isocyanate."

The polyisocyanate component according to the present invention is a component comprising bi- or higher functional isocyanate having two or more isocyanate groups in one molecule. This polyisocyanate component contains specific alicyclic isocyanate, that is, bifunctional or trifunctional alicyclic isocyanate having one or more chemical structures in which an isocyanate group is bonded to a secondary carbon atom. Here, the "secondary carbon atom" means a carbon atom directly bonded to two carbon atoms. The bifunctional or trifunctional alicyclic isocyanate is alicyclic isocyanate having two or three isocyanate groups in one molecule.

The above-described specific alicyclic isocyanate includes, for example, bifunctional or trifunctional alicyclic isocyanate having a chemical structure in which an isocyanate group is directly bonded to a cyclohexane ring, such as isophorone diisocyanate and 4,4'-methylenebis(cyclohexyl isocyanate). Also, the specific alicyclic isocyanate may be isocyanurate type or biuret type polyisocyanate that can be synthesized using the above alicyclic isocyanate as a raw material. Isocyanurate type polyisocyanate is preferred as such polyisocyanate, in terms of achieving the effect of the present invention more effectively and surely. The polyisocyanate component contains the specific alicyclic isocyanate, thereby, the cured product has more excellent high-temperature and high-humidity resistance, than a case where the polyisocyanate component contains only alicyclic polyisocyanate not having such a chemical structure, such as norbomane diisocyanate (NBDI).

The above specific alicyclic isocyanate may be synthesized by an ordinary method, or a commercially available one may be obtained. The commercially available alicyclic isocyanate includes, for example, the trade name "IPDI" and the trade name "$H_{12}MDI$" manufactured by Evonik Degussa Japan Co., Ltd.

One specific alicyclic isocyanate is used alone, or two or more specific alicyclic isocyanates are used in combination.

The polyisocyanate component preferably contains a prepolymer having a residual isocyanate group obtained by reacting bi- or higher functional isocyanate and polycaprolactone polyol having a total number of hydroxyl groups smaller than the total number of the isocyanate groups of the isocyanate. This prepolymer is obtained by the isocyanate group of the bi- or higher functional isocyanate reacting with the hydroxyl group of the polyol to produce a urethane bond. By containing this prepolymer, the curing speed of the curable resin composition is faster, and therefore, the composition is more suitable for liquid transfer molding. Also, the polyisocyanate component contains such a prepolymer, thereby, the compatibility of the polyol component and the polyisocyanate component is improved, and the degree of cure shrinkage is reduced. In this case, the bi- or higher functional isocyanate may be the specific alicyclic isocyanate, or other bi- or higher functional isocyanates.

In synthesizing the above prepolymer, the ratio of the total number of the hydroxyl groups of the polyol, which is a raw material, (X) to the total number of the isocyanate groups of the bi- or higher functional isocyanate (Y) is preferably a ratio such that X/Y is 0.05 to 0.3. If X/Y is less than 0.05, the above-described effect obtained by using the prepolymer is reduced, and therefore, the advantage of using the prepolymer tends to be hardly obtained. If X/Y is more than 0.3, the molecular weight of the prepolymer increases. As a result, the viscosity increases, and therefore, the handling of the curable resin composition tends to be difficult.

Bi- or higher functional isocyanate having an alicyclic skeleton, and/or isocyanate having an isocyanurate skeleton are preferred as bi- or higher functional isocyanate included in the polyisocyanate component according to the present invention, other than the specific alicyclic isocyanate, because of excellent light and heat discoloration resistance. Among them, 1,3-bis(isocyanatomethyl)cyclohexane, hexamethylene diisocyanate-modified, isocyanurate skeleton-containing triisocyanate, and/or norbornene diisocyanate are preferred. One of these isocyanates is used alone, or two or more of these isocyanates are used in combination.

In the first embodiment, the content of the specific alicyclic isocyanate in the polyisocyanate component is 40% by mass or more, based on the total amount of the whole polyisocyanate component. Thus, the high-temperature and high-humidity resistance of the cured product of the curable resin composition is more sufficiently high. In terms of more effectively achieving such an effect and making the curing speed faster, the above content is more preferably 40 to 85% by mass. When the bi- or higher functional isocyanate that is a raw material in synthesizing the above-described prepolymer is specific alicyclic isocyanate, the alicyclic isocyanate also applies to the above "specific alicyclic isocyanate."

In the second embodiment, the content of the tri- or higher functional polycaprolactone polyol in the polyol component is preferably 40% by mass or more, based on the total amount of the whole polyol component. Thus, the crosslinking density during curing increases sufficiently, and as a result, the hardness and toughness of the cured product is sufficiently high. In terms of more effectively achieving such an effect, the above content is more preferably 50% by mass or more. When the polyol that is a raw material in synthesizing the above-described prepolymer is tri- or higher functional polycaprolactone polyol, the polycaprolactone polyol also applies to the above "tri- or higher polycaprolactone polyol in the polyol component."

In the present invention, the polyol included in the polyol component is preferably a non-aromatic compound having no aromatic ring in the molecule. If the polyol has an aromatic ring, the discoloration resistance of the cured product of the curable resin composition to heat and light decreases. Also, the curing speed is excessively fast, and therefore, application to liquid transfer molding tends to be difficult. From a similar viewpoint, the isocyanate included in the polyisocyanate component is preferably a non-aromatic compound having no aromatic ring in the molecule. More preferably, any of the compounds included in both components is a non-aromatic compound.

The compounding ratio of the polyol component and the polyisocyanate component in the curable resin composition of the present invention is most preferably a compounding ratio such that the hydroxyl groups of the polyol component and the isocyanate groups of the polyisocyanate component are in equal amounts (equivalent). Thus, the cured product has more excellent optical properties, such as discoloration resistance to heat and light, and more excellent mechanical properties, such as hardness, heat resistance, and moisture resistance.

The curable resin composition of the present invention may contain an antioxidant, a curing catalyst, a release agent, a hindered amine light stabilizer, an ultraviolet absorber, an inorganic filler, an organic filler, a coupling agent, a polymerization inhibitor, and the like, other than the above-described polyol component and polyisocyanate component. Also, in terms of an improvement in moldability, this curable resin composition may contain a plasticizer, an antistatic agent, a flame retardant, and the like. These are preferably liquid in terms of more sufficiently obtaining the light transmissiveness of the cured product of the curable resin composition. However, when a solid one is used, one having a particle diameter smaller than the wavelength of light to be transmitted is preferred. One of these is used alone, or two or more of these are used in combination.

A hindered phenolic antioxidant is preferred as the antioxidant, particularly in terms of increasing light and heat discoloration resistance. Particularly, [2-{3-(3-tert-butyl-hydroxy-5-methylphenyl)propionyl}-1,1-dimethylet hyl]-2,4,8,10-tetraoxaspiro[5,5]undecane is preferred. This antioxidant is available as the trade name "Sumilizer GA-80" manufactured by Sumitomo Chemical Co., Ltd., which is a commercial product.

The content of the antioxidant in the curable resin composition is preferably 0.05 to 5 parts by mass, and more preferably 0.05 to 0.3 parts by mass, based on 100 parts by mass of the total amount of the polyol component and the polyisocyanate component. If this content is less than 0.05 parts by mass, the effect of the antioxidant tends to be difficult to obtain. If this content is more than 5 parts by mass, the solubility in the curable resin composition tends to decrease, and precipitation tends to occur during the curing of the curable resin composition.

The curable resin composition may contain a curing catalyst in terms of obtaining curing speed suitable for liquid transfer molding. The curing catalyst includes an organometallic catalyst, such as a zirconium catalyst and an aluminum catalyst, a tin curing catalyst, such as dibutyl tin laurate, a phenol salt of DBU, octylate, amine, imidazole, and the like. Among these, an organometallic catalyst is preferred because of excellent discoloration resistance to heat.

The content of the curing catalyst in the curable resin composition is preferably more than 0 parts by mass and 1 part by mass or less, and more preferably more than 0 parts by mass and 0.11 parts by mass or less, based on 100 parts by mass of the total amount of the polyol component and the polyisocyanate component. If this content is more than 1 part by mass, the curing speed is fast, and as a result, the handling of the curable resin composition tends to be difficult.

Also, the curable resin composition may contain a release agent in terms of increasing the release properties of the cured product from the molding die after the cavity of the molding die is filled with the curable resin composition and the curable resin composition is cured. The release agent includes, for example, polysiloxane, polyethylene, fluorine, and fatty acid ester release agents. Among these, a fatty acid ester release agent is preferred because it exhibits particularly good release properties.

The content of the release agent in the curable resin composition is preferably 0.05 to 5 parts by mass, and more preferably 0.1 to 2 parts by mass, based on 100 parts by mass of the total amount of the polyol component and the polyisocyanate component. If this content is less than 0.05 parts by mass, it tends to be difficult to sufficiently exhibit the function of the release agent. If this content is more than 5 parts by mass, the discoloration resistance of the cured product of the curable resin composition to heating tends to weaken, and the solubility of the release agent in the curable resin composition tends to decrease.

The gelation time of the curable resin composition of the present invention at 165°C is preferably 10 to 200 seconds, and more preferably 20 to 180 seconds. Thus, when the curable resin composition is molded by liquid transfer molding, it can be molded well under molding conditions (molding temperature and molding time) similar to those of solid transfer molding. Accordingly, such a curable resin composition is useful when it is molded to obtain the sealing member of a light emitting diode (hereinafter also described as an "LED") package. If the gelation time is less than 10 seconds, the liquid curable resin composition is cured before it finishes flowing sufficiently through the flow path to the molding die, and as a result, the molding die is not sufficiently filled with the curable resin composition, and it tends to be difficult to obtain a cured product (molded product) having the desired shape. If the gelation time is more than 200 seconds, an insufficiently cured, molded product tends to be easily obtained.

The gelation time of the curable resin composition can be controlled by adjusting the type and content of the curing catalyst, the content of the prepolymer, and the type and compounding proportion of the polyol and the isocyanate that provide the prepolymer.

The use of the cured product of the above-described curable resin composition of the present invention, as a sealing member for an LED, can provide an LED package that has sufficiently excellent discoloration resistance even if it is exposed to a high temperature and high humidity environment for a long time. Also, this curable resin composition is suitable for liquid transfer molding, and therefore, it is possible to shorten the molding time to increase productivity. Further, the cured product of the curable resin composition of the present invention also has good light transmissiveness at the early stage. From these viewpoints, the cured product of the curable resin composition of the present invention is particularly useful as a sealing member for an LED.

(Method for Production of LED Package)

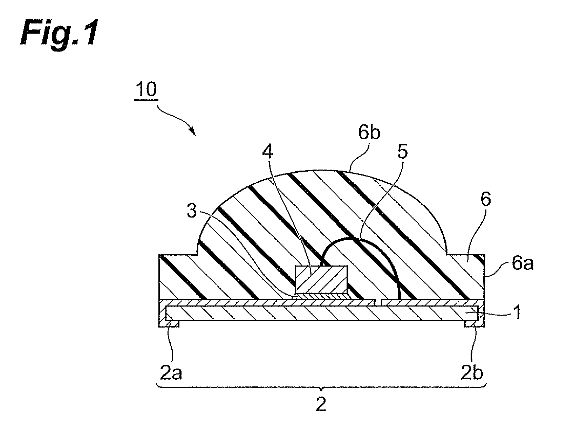

Next, a preferred embodiment of a method for production of an LED package according to the present invention will be described. The method for production of an LED package in this embodiment has the step of curing and molding the above first curable resin composition by liquid transfer molding to obtain a sealing member. The detail will be described below with a structure shown in Figure 1, as an example.

First, a liquid curable resin composition is prepared at the room temperature of the present invention, and the pot of a molding apparatus is filled with the liquid curable resin composition. Apart from this, a structure comprising one wiring board and a plurality of assemblies attached to the board is prepared. This structure comprises a wiring board, an adhesive member provided on one wiring of the wiring board, a light emitting diode device formed on the adhesive member, and a wire electrically connecting the light emitting diode device and the other wiring. This structure is placed at a predetermined position in the cavity formed by the molding die (hereinafter simply referred to as a "die") of the molding apparatus. The molding apparatus is not particularly limited as long as it is used for liquid transfer molding, and the cavity formed by its die has the intended shape of the cured product.

Next, a plunger is activated to inject the curable resin composition from the pot into the cavity of the die heated to a predetermined temperature, via a flow path, such as a runner and a gate. The die is usually composed of a separable upper die and lower die, and the cavity is formed by connecting them. Then, the curable resin composition is held in the cavity for a fixed time to cure and mold the curable resin composition filling the cavity. Thus, the cured product of the curable resin composition seals the plurality of assemblies and adheres to the structure.

The temperature of the die is preferably set to temperature such that the flowability of the curable resin composition is high in the above flow path, and that the curable resin composition can be cured in a short time in the cavity. This temperature is, for example, preferably 120 to 200°C, though also depending on the composition of the curable resin composition. The injection pressure when the curable resin composition is injected into the cavity is preferably set to pressure such that the entire cavity can be filled with the curable resin composition without clearance. Specifically, the injection pressure is preferably 2 MPa or more. If the injection pressure is less than 2 MPa, unfilled portions in the cavity tend to occur easily, and voids in the cured product tend to occur easily.

Also, a release agent may be applied or sprayed onto the inner wall surface of the die forming the cavity to easily remove the cured product of the curable resin composition from the die. Further, a publicly known evacuation apparatus that can reduce the pressure in the cavity may be used to suppress the occurrence of voids in the cured product.

Then, the structure and the cured product of the curable resin composition adhered to the structure are removed from the cavity, and then, the board and the cured product are cut (diced) so that the plurality of assemblies are individually separated. Thus, an LED package comprising the cured product of the curable resin composition described above, as a sealing member sealing the assembly, is obtained.

The method for production of an LED package in this embodiment described above uses liquid transfer molding, and therefore, the curing time can be shortened, leading to an improvement in the productivity of the LED package. Also, the use of the above molding achieves the effect of being able to provide any shape.

(LED Package)

Figure 1 shows one example of an LED package obtained by the above method for production of an LED package according to the present invention. Figure 1 is a schematic cross-sectional view of an LED package according to a preferred embodiment of the present invention. This surface-mount (or also referred to as "chip types") LED package 10 has an insulating board 1, a pair of wiring layers 2 attached to the board, an adhesive member 3 provided on one wiring 2a, a light emitting diode device 4 provided on the adhesive member 3, and a wire 5 electrically connecting the light emitting diode device 4 and the other wiring 2b, and a sealing member 6 sealing a part of the wiring layer 2, the adhesive member 3, the light emitting diode device 4, and the wire 5.

The wiring layer 2 comprises one wiring 2a and the other wiring 2b. One wiring 2a and the other wiring 2b are separated from each other. The adhesive member 3 is a member for adhering and fixing one wiring 2a and the light emitting diode device 4 to each other and electrically connecting them. The adhesive member 3 is formed of, for example, a silver paste.

The light emitting diode device 4 is not particularly limited as long as it is a semiconductor device that emits light when voltage is applied in the forward direction. The light emitting diode device 4 may be a publicly known light emitting diode device. The wire 5 should be a conductive wire, such as a thin metal wire, that can electrically connect the light emitting diode device 4 and the other wiring 2b.

The sealing member 5 is formed of the cured product of the curable resin composition of the present invention. This sealing member 5 has the function of protecting the light emitting diode device 4 from the outside air and extracting light emitted from the light emitting diode device 4 to the outside, and therefore, the sealing member 5 exhibits high light transmissiveness. In this embodiment, the sealing member 5 is formed of a flat plate-shaped part 6a on the board side and a lens part 6b on the side opposite to the board, and light emitted from the light emitting diode device 4 is focused by the lens part 6b having a convex lens shape.

The LED package 10 in this embodiment described above uses the cured product of the curable resin composition of the present invention as a sealing member, which is a member susceptible to temperature and humidity. Therefore, the LED package 10 is an LED package that has sufficiently excellent luminance maintenance even if it is exposed to a high temperature and high humidity environment for a long time. Also, liquid transfer molding can be used in a part of the production process, thereby, it is possible to shorten the molding time to increase productivity. Further, the sealing member also has good light transmissiveness at the early stage, and therefore, high luminance can be maintained for a long time. Also, the use of liquid transfer molding achieves the effect of being able to provide a lens shape such that the light extraction efficiency is improved, as in Figure 1.

The preferred embodiments of the present invention have been described above, but the present invention is not limited to the above embodiments. Various modifications can be made in the present invention without departing from the gist thereof.

For example, in another embodiment according to the method for production of an LED package according to the present invention, when the sealing member is formed, cast molding or potting may be used, though the productivity is poorer than that in liquid transfer molding. In this case, the heating temperature and heating time required for the curing of the curable resin composition are preferably 60 to 150°C and 1 to 10 hours, and more preferably 80 to 150°C and 1 to 10 hours, though also depending on the composition of the curable resin composition. Also, the heating is preferably performed with the temperature raised gradually or stepwise, to reduce the internal stress in the cured product, which occurs with curing.

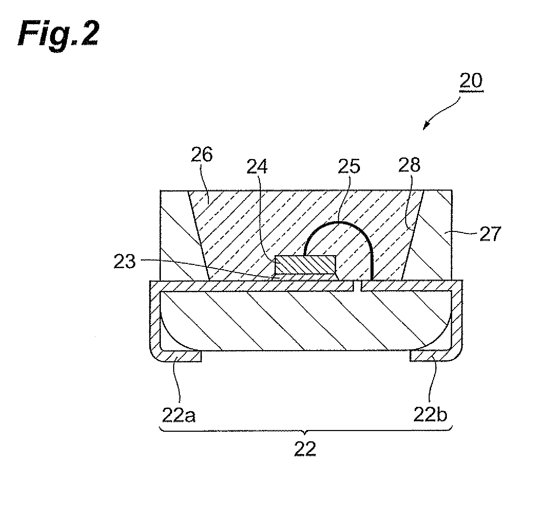

Also, the LED package is not limited to that in the above embodiment as long as it comprises the cured product of the curable resin composition of the present invention as the sealing member. For example, the LED package may be an LED package shown in Figure 2. A surface-mount LED package 20 shown in a schematic cross-sectional view in Figure 2 comprises a light emitting diode device 24, and a sealing member 26 having light transmissiveness, which is provided to seal the light emitting diode device 24. The light emitting diode device 24 is located in the bottom part of a cavity part 28 formed by a case member 27. The light emitting diode device 24 is electrically connected to one lead frame 22a via an adhesive member 23 and is electrically connected to the other lead frame 22b via a wire 25. In this LED package 20, the sealing member 26 is formed of the cured product of the curable resin composition of the present invention. The surface of the sealing member 26 is flat and does not have the function of focusing light emitted from the light emitting diode device 24.

The pair of lead frames 22 are fit and attached to the case member 27. The pair of lead frames 22, the adhesive member 23, the light emitting diode device 24, and the wire 25 should be of materials similar to those of the wiring layer 2, the adhesive member 3, the light emitting diode device 4, and the wire 5 in the above embodiment, respectively. The case member 27 has a shape such that the curable resin composition can be held in the cavity part 28, and the opening portion of the cavity part 28 is circular.

Further, the LED package of the present invention is not limited to a surface-mount type and may be a shell type.

(Second Curable Resin Composition)

Next, the second curable resin composition of the present invention will be described. The second curable resin composition of the present invention comprises a polyol component, and bi- or higher functional isocyanurate type isocyanate having one or more chemical structures in which an isocyanate group is bonded to a secondary carbon atom, wherein the cured product of the second curable resin composition has a glass transition temperature of 110°C or more, a thermal expansion coefficient of $10.0\times10^{-5}$/°C or less at the glass transition temperature or lower, a thermal expansion coefficient of $20.0\times10^{-5}$/°C or less at the glass transition temperature or higher, and a flexural modulus of 1500 MPa or more at 25°C.

The first and second curable resin compositions of the present invention are "two-part resin compositions" in which an A liquid comprising a polyol component, and a B liquid comprising a polyisocyanate component are reacted to obtain a cured product.

The breaking of the wire and detachment in the temperature cycle test of an optical semiconductor largely depend on the curing properties of the resin sealing the device, and when the cured product has a flexural modulus of 1000 MPa or more at 25°C and is hard, the effect of the stress relaxation of the resin itself is small. Therefore, the thermal expansion coefficient is preferably as small as possible, and the glass transition temperature is preferably the upper limit, or more, of the test temperature range.

The curing of the curable resin composition in the present invention provides a cured product in which a three-dimensional crosslinked structure is formed by the reaction of the hydroxyl groups of the polyol and the isocyanate groups. The curing properties of the cured product, such as glass transition temperature, a thermal expansion coefficient, and a flexural modulus, depend on the type of the polyol and the isocyanate, the amount of the polyol and the isocyanate compounded, and the like. Particularly, the use of isocyanurate type isocyanate as the polyisocyanate component can intend higher glass transition temperature and a reduced thermal expansion coefficient.

Also, the use of bi- or higher functional isocyanurate type isocyanate having one or more chemical structures in which an isocyanate group is bonded to a secondary carbon atom of an alicyclic skeleton, as the polyisocyanate component, can suppress a decrease in luminance in a continuous lighting test under high-temperature and high-humidity conditions, compared with the use of isocyanate in which an isocyanate group is bonded to a primary carbon atom, for example, when the curable resin composition is used for the sealing of an LED.

Similarly, the use of tri- or higher functional polycaprolactone polyol having a weight-average molecular weight of 500 or less and a hydroxyl group value of 300 mgKOH/g or more, and tri- or higher functional aliphatic polyol having a weight-average molecular weight of 350 or less and a hydroxyl group value of 500 mgKOH/g or more, as the polyol component, can intend higher glass transition temperature and a reduced thermal expansion coefficient.

Also, a polyol component $P_A$ liquid containing a prepolymer having a residual hydroxyl group obtained by reacting polyol and bi- or higher functional isocyanate having a total number of isocyanate groups smaller than the total number of the hydroxyl groups of the polyol is preferably used as the polyol component. Further, a polyisocyanate component $P_B$ liquid containing a prepolymer having a residual isocyanate group obtained by reacting bi- or higher functional isocyanate and polyol having a total number of hydroxyl groups smaller than the total number of the isocyanate groups of the isocyanate is preferably used as the polyisocyanate component. Preferably, the above $P_A$ liquid comprising an amount of hydroxyl groups equal to the amount of the residual isocyanate groups of the above $P_B$ liquid is reacted to make a cured product. In the following description, with respect to the above $P_A$ liquid and the above $P_B$ liquid, a polyol component not containing the above prepolymer is referred to as an "A liquid," and a polyisocyanate component not containing the above prepolymer is referred to as a "B liquid."

These $P_A$ liquid and $P_B$ liquid are preferably used to make the cured product of the resin because there are advantages that the cure shrinkage is smaller and the compatibility is more excellent than when a cured product is made from the monomers of a polyol component and a polyisocyanate component. Further, these $P_A$ liquid and $P_B$ liquid can be used for a fast curing and molding process, such as liquid transfer molding, because the curing speed is fast.

When the $P_B$ liquid is made, tri- or higher functional aliphatic polyol having a weight-average molecular weight of 350 or less and a hydroxyl group value of 500 mgKOH/g or more is preferably used as polyol. This is to advantageously act on the above compatibility and fast curing properties by previously reacting components having slow reaction speed in the polyol component and the polyisocyanate component to provide a prepolymer.

The prepolymer in the above $P_B$ liquid is preferably obtained by reacting the above polyol and the above isocyanate at a ratio of a hydroxyl group equivalent X in the above polyol to an isocyanate group equivalent Y in the above isocyanate (X/Y) of 0.05 to 0.30. If the above ratio (X/Y) is more than 0.30, there is a problem that the molecular weight of the prepolymer increases, and therefore, the viscosity is high and the handling is difficult. If the ratio (X/Y) is less than 0.05, the effect of prepolymerization is hardly obtained. Also, the synthesis of the prepolymer can be shortened by adding a catalyst, but preferably, reaction is performed at room temperature or while heating, in the absence of a catalyst, to avoid discoloration.

Similarly, the prepolymer in the above $P_A$ liquid is preferably obtained by reacting the above polyol and the above isocyanate at a ratio of a hydroxyl group equivalent X in the above polyol to an isocyanate group equivalent Y in the above isocyanate (X/Y) of 3 or more. If the above ratio (X/Y) is less than 3, the effect of prepolymerization is hardly obtained.

The bi- or higher functional isocyanurate type isocyanate having one or more chemical structures in which an isocyanate group is bonded to a secondary carbon atom, used in the present invention, is particularly desirably a trimer of isophorone diisocyanate(3-isocyanatemethyl-3,5,5-trimethyloyclohexyl isocyanate) and may be a trimer of 1,3-bis (isocyanatomethyl)cyclohexane. In a trimer of isophorone diisocyanate, isocyanate groups bonded to primary carbon form an isocyanurate ring, and the residual three isocyanate groups are bonded to a secondary carbon atom of an alicyclic skeleton.

Other isocyanates in the polyisocyanate component are preferably isocyanate having an alicyclic skeleton and include 1,3-bis(isocyanatomethyl)cyclohexane, norbornene diisocyanate(2,5-(2,6)bisisocyanatomethyl[2,2,1]heptane), isophorone diisocyanate, 4-4'methylenebis(cyclohexyl isocyanate), isopropylidenebis(4-cyclohexyl isocyanate), cyclohexyl diisocyanate, and the like. Among these, particularly, 1,3-bis(isocyanatomethyl)cyclohexane and norbornene diisocyanate(2,5-(2,6)bisisocyanatomethyl[2,2,1]heptane) are preferred. Also, a plurality of types of alicyclic diisocyanate may be mixed and used.

The proportion of the bi- or higher functional isocyanurate type isocyanate having one or more chemical structures in which an isocyanate group is bonded to a secondary carbon atom, in the polyisocyanate component, is preferably 40% by mass or more, based on the total amount of the solids in the polyisocyanate component. If the proportion of the isocyanurate type isocyanate is less than 40% by mass, it tends to be difficult to obtain a glass transition temperature of 110°C or more.

Trimethylolpropane and propane-1,2,3-triol are preferred as the tri- or higher functional aliphatic polyol having a weight-average molecular weight of 350 or less and a hydroxyl group value of 500 mgKOH/g or more in the polyol component used in the present invention. Also, derivatives of the aliphatic polyols may be used. Derivatives obtained by adding ethylene oxide or propylene oxide are preferred as the aliphatic polyol derivatives. However, though also depending on the amount of the aliphatic polyol derivative compounded, the aliphatic polyol derivative desirably has a weight-average molecular weight of 350 or less, in order that the cured product has a glass transition temperature of 110°C or more.

For the compounding ratio of the components in the polyol component, preferably, the tri- or higher functional polycaprolactone polyol having a weight-average molecular weight of 500 or less and a hydroxyl group value of 300 mgKOH/g or more is 40% by mass or more, and the tri- or higher functional aliphatic polyol having a weight-average molecular weight of 350 or less and a hydroxyl group value of 500 mgKOH/g or more is 30% by mass or more, based on the total amount of the solids in the polyol component. If the above compounding ratio of the components is less than the above lower limit value, it tends to be difficult for the cured product to have a glass transition temperature of 110°C or more.

Also, caprolactone diol, carbonate diol, polyester diol, polyether diol, aliphatic diol, such as 1,4-butanediol and 1,3-propanediol, and the like are preferred as other polyol types in the polyol component.

Further, the curable resin composition of the present invention may comprise a hindered phenolic antioxidant, and any of the above A liquid, B liquid, $P_A$ liquid, and $P_B$ liquid may comprise the hindered phenolic antioxidant. In terms of solubility, preferably, a liquid comprising a large amount of the polyisocyanate component contains the hindered phenolic antioxidant. The use of the hindered phenolic antioxidant in combination can significantly improve the light resistance, heat resistance, mechanical properties of the cured product of the curable resin.

The above hindered phenolic antioxidant includes, for example, 3,9-bis[2-{3-(3-tert-butyl-4-hydroxy-5-methylphenyl)propionyl}-1,1-di methylethyl]-2,4,8,10-tetraoxaspiro[5,5]undecane, benzenepropanoic acid, 3,5-bis(1,1-dimethylethyl)-4-hydroxy, C7-C9 side chain alkyl ester, 4,4'-butylidenebis(6-tert-butyl-3-methylphenol), 2,6-di-tert-butyl-4-methylphenol, and 2,2'-methylenebis(6-tert-butyl-4-methylphenol). Among these, particularly, 3,9-bis[2-{3-(3-tert-butyl-4-hydroxy-5-methylphenyl)propionyl}-1,1-di methylethyl]-2,4,8,10-tetraoxaspiro[5,5]undecane and benzenepropanoic acid, 3,5-bis(1,1-dimethylethyl)-4-hydroxy, G7-C9 side chain alkyl ester are preferred.

The amount of the above antioxidant added is preferably 0.05 to 5% by mass, and more preferably 0.05 to 0.3% by mass, based on the total amount of the solids in the curable resin composition. If the amount of the antioxidant added is less than 0.05% by mass, the effect of the antioxidant tends to be not sufficiently obtained. On the other hand, if the amount of the antioxidant added is more than 5% by mass, the problem of solubility, that is, the problem of precipitation during curing, and the like tend to occur.

Generally, the reactivity of a hydroxyl group and an alicyclic isocyanate group is slower than the reactivity of a hydroxyl group and aromatic isocyanate, and therefore, the curing time can be shortened by adding a curing catalyst.

This catalyst is not particularly limited and includes, for example, an organometallic catalyst of zirconium or aluminum, dibutyl tin laurate, a phenol salt of DBU, octylate, amine, imidazole, and the like. Among these, particularly, an organometallic catalyst, for example, aluminum sec-butylate, ethylacetoacetate aluminum diisopropylate, zirconium tributoxyacetylacetonate, zirconium tetraacetylacetonate, and the like are preferred in terms of discoloration properties.

The amount of the above catalyst added is preferably 1% by mass or less, and particularly preferably 0.1% by mass or less, based on the total amount of the solids in the curable resin composition. If the amount of the catalyst added is more than 1% by mass, the curing speed is too fast, and therefore, the handling of the curable resin composition tends to be difficult. As the amount of the catalyst added increases, discoloration tends to occur more easily.

Other than the above components, a hindered amine light stabilizer, a phosphorous antioxidant, an ultraviolet absorber, an inorganic filler, an organic filler, a coupling agent, a polymerization inhibitor, and the like can be added to the curable resin composition of the present invention. Also, in terms of moldability, a release agent, a plasticizer, an antistatic agent, a flame retardant, and the like may be added. These are preferably liquid in terms of obtaining the light transmissiveness of the cured product of the curable resin, but when they are solid, they desirably have a particle diameter equal to or less than the wavelength used.

Fatty acid ester, polysiloxane, polyethylene, and fluorine release agents can be added as the release agent. Among these, particularly, a fatty acid ester release agent is preferred. The amount of the release agent added is preferably 0.05 to 5 parts by mass, and more preferably 0.1 to 2 parts by mass, based on 100 parts by mass of the total amount of the solids in the mixture of the polyol component and the isocyanate component. If the amount of the release agent added is less than 0.05 parts by mass, the effect of the release agent tends to be not easily sufficiently obtained. On the other hand, if the amount of the release agent added is more than 5 parts by mass, problems in discoloration and solubility tend to occur.

In the curable resin composition of the present invention, the gelation time at 165°C is preferably 10 to 200 seconds. With the gel time in this range, it is possible to seal an optical semiconductor device with the resin and make an optical member by liquid transfer molding under substantially the same molding conditions as those of conventional solid transfer molding. If the gelation time is less than 10 seconds, the curable resin composition solution is cured before it finishes flowing sufficiently through the flow path in the molding die, and therefore, unfilled sites and voids in the molded product tend to occur easily. On the other hand, if the gelation time is more than 200 seconds, an insufficiently cured, molded product tends to be provided.

In the curable resin composition of the present invention, the compounding ratio of the polyol component (the above A liquid and/or the above $P_A$ liquid) and the polyisocyanate component (the above B liquid and/or the above $P_B$ liquid) is preferably a compounding ratio such that the ratio of the hydroxyl group equivalent in the polyol component to the isocyanate group equivalent in the polyisocyanate component (hydroxyl group equivalent/isocyanate group equivalent) is 0.7 to 1.3, more preferably 0.8 to 1.1. If this ratio is out of the range of 0.7 to 1.3, the heat resistance, optical properties, and mechanical properties of the cured product tend to decrease.

(Optical Semiconductor)

The method for production of a cured product (an optical member or the like) using the curable resin composition of the present invention is not particularly limited and includes, for example, a method for obtaining a cured product by mixing the polyol component (the above A liquid and/or the above $P_A$ liquid) and the polyisocyanate component (the above B liquid and/or the above $P_B$ liquid), casting or potting the curable resin composition solution or flowing the curable resin composition solution into a die after the curable resin composition solution becomes uniform, and heating and curing the curable resin composition solution, and the like. When curing is performed for a short time by liquid transfer molding, a combination of the A liquid and the $P_B$ liquid is preferred.

The method for stirring these two liquids includes methods of rotary stirring, ultrasonic dispersion, and the like, and stirring should be performed so that the curable resin composition is uniform. Also, after the curable resin composition is mixed, the curable resin composition can be frozen and stored to provide a one-part curable resin composition solution. In this case, it can be thawed at room temperature for use, before casting or potting.

Before the resin mixture is cast, potted, or flowed into a die, the resin mixture is desirably vacuum-defoamed to remove bubbles trapped during mixing, and carbon dioxide produced by the reaction of the isocyanate and the moisture in air.

The heating conditions when curing is performed by casting or potting are preferably 60 to 150°C for about 1 to 10 hours, and more preferably 80 to 150°C for about 1 to 5 hours, though also depending on the type and combination of the components. Also, the curing temperature is desirably raised stepwise to reduce internal stress, which occurs due to rapid curing reaction.

The optical semiconductor of the present invention comprises a member (an optical member, a sealing member, and the like) obtained by molding the above curable resin composition of the present invention by liquid transfer molding. An optical semiconductor device can be sealed with the resin, and an optical member can be made, using liquid transfer molding, for example, by injecting the curable resin composition of the present invention into the pot of a molding apparatus, operating a plunger to transfer the curable resin composition in the pot to the cavity part formed by the upper die and the lower die, and then, heating and curing the curable resin composition. The die temperature is desirably temperature such that the curable resin composition can move in the flow path of the die and can be cured in the cavity in a short time. The die temperature is preferably about 120°C to 200°C.

The injection pressure of the curable resin composition should be pressure in a range that unfilled portions and voids do not occur in the resin-molded product in the cavity, and the injection pressure is not particularly limited and is preferably 2 MPa or more. If the injection pressure is less than 2 MPa, unfilled portions tend to occur easily.

Also, a release agent can be applied and sprayed on the die side to improve release properties. Further, an evacuation apparatus can also be used to suppress the occurrence of voids. The apparatus that can perform evacuation is not particularly limited, and a publicly known apparatus can be used. Also, in the case of liquid transfer molding, post-curing is desirably performed after molding, as required.

The curable resin composition of the present invention described above is preferred as a sealing resin, because a cured product thereof has high optical transparency, excellent optical properties, such as heat and light discoloration resistance, and excellent mechanical properties, for use in optical semiconductor devices, such as a light emitting diode (LED), a phototransistor, a photodiode, and a solid-state image pickup device. Also, by using the curable resin composition of the present invention, an optical semiconductor device can be efficiently sealed with the resin by liquid transfer molding, and an optical semiconductor, such as an LED, can be produced with good productivity.

**Examples**

The present invention will be described below in more detail by examples, but the present invention is not limited to these examples.

(Example 1)

A mixture obtained by mixing 28.3 parts by mass or polycaprolactone triol A1 having a weight-average molecular weight of 300 and a hydroxyl group value of 540 mgKOH/g (manufactured by DAICEL CHEMICAL INDUSTRIES, LTD., the trade name "PLACCEL 303") and 28.3 parts by mass of polycarbonate diol A2 having a weight-average molecular weight of 500 and a hydroxyl group value of 230 mgKOH/g (manufactured by DAICEL CHEMICAL INDUSTRIES, LTD., the trade name "PLACCEL CD205PL"), as a polyol component, 43.3 parts by mass of isophorone diisocyanate B1 (manufactured by Evonik Degussa Japan Co., Ltd., the trade name "IPDI") as a polyisocyanate component, and 0.1 parts by mass of [2-{3-(3-tert-butyl-4-hydroxy-5-methylphenyl)propionyl}-1,1-dimethyl ethyl]-2,4,8,10-tetraoxaspiro[5,5]undecane C1 (manufactured by Sumitomo Chemical Co., Ltd., the trade name "Sumilizer GA-80") as a hindered phenolic antioxidant was uniformly dispersed and dissolved by ultrasonic dispersion, and then defoamed at reduced pressure to obtain a curable resin composition solution S1.

Also, the assembly of the LED package shown in Figure 2, without the sealing member, was prepared in the following manner. A case member (outer dimensions: 3.2 mm wide × 2.6 mm deep × 1.8 mm thick) made of polyphthalimide, with a cavity part having an opening portion having a diameter of 2.4 mm, was formed on lead frames having a shape similar to that shown in Figure 2, by insert molding. Next, a light emitting diode device (light emission wavelength: 470 nm) was mounted, via a silver paste, on the lead frame exposed in the bottom part of the cavity part. Then, the terminal of the lead frame on which the light emitting diode device is not mounted, and the light emitting diode device were connected by wire bonding using a gold wire to obtain the assembly.

Next, the above-described curable resin composition solution S1 was flowed into the cavity part in the above assembly and filled the cavity part. Then, the filling curable resin composition solution S1 was subjected to heating and curing treatment under conditions of 80°C for 1 hour, 100°C for 1 hour, 120°C for 1 hour, and 150°C for 3 hours to obtain a cured product as a sealing member. Thus, an LED package was completed.

(Example 2)

A mixture obtained by mixing 35.0 parts by mass of the above polycaprolactone triol A1 and 7.0 parts by mass of the above polycarbonate diol A2 as a polyol component, 28.7 parts by mass of 4,4'-methylenebis(cyclohexyl isocyanate) B2 (manufactured by Evonik Degussa Japan Co., Ltd., the trade name "H$_{12}$MDI") and 29.4 parts by mass of isocyanurate type triisocyanate B3 (manufactured by Asahi Kasei Chemicals Corporation, the trade name "DURANATE THA-100") as a polyisocyanate component, and 0.1 parts by mass of the above [2-{3-(3-tert-butyl-4-hydroxy-5-methylphenyl)propionyl}-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S2.

Then, an LED package was completed as in Example 1 except that this curable resin composition solution S2 was used instead of the curable resin composition solution S1.

(Example 3)

A mixture obtained by mixing 40.9 parts by mass of the above polycaprolactone triol A1 and 4.5 parts by mass of trimethylolpropane A3 (manufactured by Perstorp) as a polyol component, 25.8 parts by mass of the above 4,4'-methylenebis(cyclohexyl isocyanate) B2 and 29.7 parts by mass of 1,3-bis(isocyanatemethyl)cyclohexane B4 (manufactured by Mitsui Chemicals Polyurethanes, Inc., the trade name "TAKENATE T600") as a polyisocyanate component, and 0.1 parts by mass of the above [2-{3-(3-tert-butyl-4-hydroxy-5-methylphenyl)propionyl}-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S3.

Then, an LED package was completed as in Example 1 except that this curable resin composition solution S3 was used instead of the curable resin composition solution S 1.

(Example 4)

First, 2.8 parts by mass of the above trimethylolpropane A3 as a polyol component and 27.6 parts by mass of the above 4,4'-methylenebis(cyclohexyl isocyanate) B2 as a polyisocyanate component were mixed, and then, the mixture was stirred at 100°C for 3 hours to obtain a prepolymer P1.

A mixture obtained by mixing 30.4 parts by mass of the above prepolymer P1, 21.7 parts by mass of the above polycaprolactone triol A1 and 11.7 parts by mass of trimethylolpropane A3 as a polyol component, 10.7 parts by mass of the above isocyanurate type triisocyanate B3 and 25.6 parts by mass of the above 1,3-bis(isocyanatemethyl) cyclohexane B4 as a polyisocyanate component, and 0.1 parts by mass of the above [2-{3-(3-tert-butyl-4-hydroxy-5-methylphenyl)propionyl}-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S4.

Then, an LED package was completed as in Example 1 except that this curable resin composition solution S4 was used instead of the curable resin composition solution S 1.

(Example 5)

A mixture obtained by mixing 23.3 parts by mass of the above polycaprolactone triol A1 and 23.3 parts by mass of the above polycarbonate diol A2 as a polyol component, 20.9 parts by mass of the above 4,4'-methylenebis(cyclohexyl isocyanate) B2 and 32.1 parts by mass of the above isocyanurate type triisocyanate B3 as a polyisocyanate component, and 0.1 parts by mass of the above [2-{3-(3-tert-butyl-4-hydroxy-5-methylphenyl)propionyl}-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S5.

Then, an LED package was completed as in Example 1 except that this curable resin composition solution S5 was used instead of the curable resin composition solution S1.

(Example 6)

A mixture obtained by mixing 29.9 parts by mass of polycaprolactone triol A4 having a weight-average molecular weight of 500 and a hydroxyl group value of 310 mgKOH/g (manufactured by DAICEL CHEMICAL INDUSTRIES, LTD., the trade name ""PLACCEL 305") and 29.0 parts by mass of the above polycarbonate diol A2 as a polyol component, 29.6 parts by mass of the above 4,4'-methylenebis(cyclohexyl isocyanate) B2 and 11.4 parts by mass of the above isocyanurate type triisocyanate B3 as a polyisocyanate component, and 0.1 parts by mass of the above [2-{3-(3-tert-butyl-4-hydroxy-5-methylphenyl)propionyl}-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S6.

Then, an LED package was completed as in Example 1 except that this curable resin composition solution S6 was used instead of the curable resin composition solution S1.

(Comparative Example 1)

A mixture obtained by mixing 30.1 parts by mass of the above polycaprolactone triol A1 and 6.0 parts by mass of the above polycarbonate diol A2 as a polyol component, 63.4 parts by mass of the above isocyanurate type triisocyanate B3 as a polyisocyanate component, and 0.1 parts by mass of the above [2-{3-(3-tert-butyl-4-hydroxy-5-methylphenyl)propionyl}-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S6.

Then, an LED package was completed as in Example 1 except that this curable resin composition solution S6 was used instead of the curable resin composition solution S1.

(Comparative Example 2)

A mixture obtained by mixing 51.8 parts by mass of the above polycaprolactone triol A1 as a polyol component, 48.2 parts by mass of the above 1,3-bis(isocyanatemethyl)cyclohexane B4 as a polyisocyanate component, and 0.1 parts by mass of the above [2-{3-(3-tert-butyl-4-hydroxy-5-methylphenyl)propionyl]-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S7.

Then, an LED package was completed as in Example 1 except that this curable resin composition solution S7 was used instead of the curable resin composition solution S1.

(Comparative Example 3)

A mixture obtained by mixing 50.3 parts by mass of the above polycaprolactone triol A1 as a polyol component, 49.7 parts by mass of norbornene diisocyanate B5 (manufactured by Mitsui Takeda Chemicals Inc., the trade name "COSMONATE NBDI") as a polyisocyanate component, and 0.1 parts by mass of the above [2-{3-(3-tert-butyl-4-hydroxy-5-methylphenyl)propionyl}-1,1-dimethyl ethyl]-2,4,8,10-tetraoxaspiro[5,5]undecane C1 as a hindered phenolic antioxidant was uniformly dispersed and dissolved by ultrasonic dispersion, and then defoamed at reduced pressure to obtain a curable resin composition solution S8.

Then, an LED package was completed as in Example 1 except that this curable resin composition solution S8 was used instead of the curable resin composition solution S1.

The composition of the curable resin compositions in the above-described Examples and Comparative Examples is collectively shown in Table 1.

[Table 1]

| | | Example | | | | | | Comp. Ex. | | |
|---|---|---|---|---|---|---|---|---|---|---|
| | | 1 | 2 | 3 | 4 | 5 | 6 | 1 | 2 | 3 |
| Polyol component | A1 | 28.3 | 35.0 | 40.9 | 21.7 | 23.3 | --- | 30.1 | 51.8 | 50.3 |
| | A2 | 28.3 | 7.0 | --- | --- | 23.3 | 29.0 | 6.0 | --- | --- |
| | A3 | --- | --- | 4.5 | 11.7 | --- | --- | --- | --- | --- |
| | A4 | --- | --- | --- | --- | --- | 29.9 | --- | --- | --- |
| Polyisocyanate component | B1 | 43.3 | --- | --- | --- | --- | --- | --- | --- | --- |
| | B2 | --- | 28.7 | 25.8 | --- | 20.9 | 29.6 | --- | --- | --- |
| | B3 | --- | 29.4 | --- | 10.7 | 32.1 | 11.4 | 63.4 | --- | --- |
| | B4 | --- | --- | 28.7 | 25.6 | --- | --- | --- | 48.2 | --- |
| | B5 | --- | --- | --- | --- | --- | --- | --- | --- | 49.7 |
| Prepolymer P1 | A3 | --- | --- | --- | 2.8 | --- | --- | --- | --- | --- |
| | B2 | --- | --- | --- | 27.6 | --- | --- | --- | --- | --- |
| Antioxidant | C1 | 0.1 | 0.1 | 0.1 | 0.1 | 0.1 | 0.1 | 0.1 | 0.1 | 0.1 |

[High-Temperature and High-Humidity Lighting Test]

A DC 20 mA current was flowed through the obtained LED package to light the LED. Luminance L1 at this time was measured using an instantaneous multiphotometer (manufactured by Otsuka Electronics Co., Ltd.). Then, the LED package was located in a constant temperature and humidity vessel at 85°C and 85% RH, and a DC 20 mA current was flowed through the LED package to maintain the LED in a lighted state for 1000 hours. Then, the LED package was removed from the constant temperature and humidity vessel, a DC 20 mA current was flowed to light the LED, and luminance L2 was measured. The ratio of luminance before and after the LED package was located in the constant temperature and humidity vessel (L2/L1) was a "luminance maintenance rate." A case where this luminance maintenance rate was 0.8 or more was evaluated as "A," a case where this luminance maintenance rate was 0.7 or more and less than 0.8 was evaluated as "B," and a case where this luminance maintenance rate was less than 0.7 was evaluated as "C." The results are shown in Table 2.
[Table 2]

| | Example | | | | | | Comp. Ex. | | |
|---|---|---|---|---|---|---|---|---|---|
| | 1 | 2 | 3 | 4 | 5 | 6 | 1 | 2 | 3 |
| High-temperature and high-humidity lighting test | A | A | A | A | B | A | C | C | C |
| Gelation time (sec.) | 172 | 50 | 169 | 138 | 47 | 87 | 44 | 106 | 95 |
| Liquid transfer moldability test | A | A | A | A | A | A | A | A | A |

[Measurement of Gelation Time]

0.2 g of the curable resin composition obtained as described above was placed on a hot plate heated to 165°C, and the gelation time was measured by hand curing using a gelation tester (manufactured by SYSTEM SEIKO). The results are shown in Table 2.

[Liquid Transfer Moldability Test]

The pot of a molding apparatus for transfer molding was filled with the curable resin composition solution obtained as described above. Then, a plunger was activated to inject the curable resin composition from the pot into the cavity of the die heated to 165 to 175°C, via the flow path. The injection pressure was 4 to 15 MPa, and the time of injecting the curable resin composition into the cavity was 20 to 50 seconds. Then, the curable resin composition was held in the cavity for 180 to 300 seconds. For the heating temperature of the die, the injection pressure, the injection time, and the holding time, conditions were appropriately set according to the resin because the temperature dependence of the curing speed, the ease of occurrence of voids, the ease of filling, and the like were different depending on the resin used and the shape of the die. The thus obtained LED package shown in Figure 1, with outer dimensions of 5.1 mm $\times$ 3.9 mm $\times$ 4.7 mm, was observed with a microscope. A case where voids and unfilled portions were not observed in its appearance was evaluated as "A," and a case where either voids or unfilled portions were observed was evaluated as "C." The results are shown in Table 2.
The LED package in Example 5 was "B" in the high-temperature and high-humidity lighting test because the amount of 4,4'-methylenebis(cyclohexyl isocyanate) in the curable resin composition was smaller than that in Example 2.

(Example 7)

For a polyol component, 5.0 parts by mass of trimethylolpropane A3 (manufactured by Perstorp) and 1.5 parts by mass of polycarbonate diol A2 having a weight-average molecular weight of 500 and a hydroxyl group value of 230 mgKOH/g (manufactured by DAICEL CHEMICAL INDUSTRIES, LTD., the trade name "PLACCEL CD205PL") were added to 7.8 parts by mass of polycaprolactone triol A1 having a weight-average molecular weight of 300 and a hydroxyl group value of 540 mgKOH/g (manufactured by DAICEL CHEMICAL INDUSTRIES, LTD., the trade name "PLACCEL 303"), and they were heated and stirred to obtain a uniform polyol component A liquid.
On the other hand, 0.56 parts by mass of the above (A3) was added to 8.0 parts by mass of 4,4'-methylenebis (cyclohexyl isocyanate) B6 (manufactured by Sumitomo Bayer Urethane Co., Ltd., the trade name "Desmodur W"), and they were reacted in a nitrogen atmosphere at 100°C for 1 hour to make a prepolymer having a residual isocyanate group.
Also, 8.56 parts by mass of the above prepolymer, 8.4 parts by mass of norbornene diisocyanate B5 (manufactured by Mitsui Takeda Chemicals Inc., the trade name "COSMONATE NBDI"), and 21.7 parts by mass of a butyl acetate solution of 70% by mass of isocyanurate type isocyanate, which is a trimer of isophorone diisocyanate, B7 (manufactured by Degussa, the trade name "VESTANAT T1890"), as a polyisocyanate component, and 0.05 parts by mass of 3,9-bis[2-{3-(3-tert-butyl-4-hydroxy-5-methylphenyl)propionyl}-1,1-di methylethyl]-2,4,8,10-tetraoxaspiro[5,5] undecane C1 (manufactured by Sumitomo Chemical Co., Ltd., the trade name "Sumilizer GA-80") as a hindered phenolic antioxidant were mixed, and then, the butyl acetate was removed by heating at reduced pressure to obtain a polyisocyanate component $P_B$ liquid.
14.3 parts by mass of the above A liquid and 32.2 parts by mass of the above $P_B$ liquid were mixed (hydroxyl group equivalent/isocyanate group equivalent ratio = 1.0) to obtain a curable resin composition solution. The obtained curable resin composition solution was defoamed at reduced pressure, then flowed into a die having a 3 mm thick silicone spacer sandwiched by glass plates, and heated and cured at 80°C for 1 hour, at 100°C for 1 hour, and at 150°C for 2 hours to make a 3 mm thick cured product.

Also, the curable resin composition solution after defoaming at reduced pressure was cast into the cavity part of a surface-mount LED made of polyphthalamide and having outer dimensions of 3.2 mm × 2.6 mm × 1.8 mm and a cavity inner diameter of 2.4 mm($\varphi$), in which an LED device was mounted, and the curable resin composition solution was heated and cured at 80°C for 1 hour, at 100°C for 1 hour, and at 150°C for 2 hours to make a surface-mount LED package.

(Example 8)

For a polyol component, 5.9 parts by mass of the above (A3) and 1.5 parts by mass of the above (A2) were added to 5.7 parts by mass of the above (A1), and they were heated and stirred to provide a uniform polyol component A liquid.

On the other hand, 0.65 parts by mass of the above (A3) was added to 8.0 parts by mass of the above (B6), and they were reacted in a nitrogen atmosphere at 100°C for 1 hour to make a prepolymer having a residual isocyanate group.

Also, 8.65 parts by mass of the above prepolymer, 8.4 parts by mass of the above (B5), 21.7 parts by mass of the above (B7), and 0.05 parts by mass of the above (C1), as a polyisocyanate component, were mixed, and then, the butyl acetate was removed by heating at reduced pressure to make a polyisocyanate component $P_B$ liquid.

13.1 parts by mass of the above A liquid and 32.3 parts by mass of the above $P_B$ liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

(Example 9)

For a polyol component, 32.9 parts by mass of the above (A3) and 8.4 parts by mass of the above (A2) were added to 32.2 parts by mass of the above (A1), and they were heated and stirred to provide a uniform polyol component A liquid.

On the other hand, 3.6 parts by mass of the above (A3) was added to 30.0 parts by mass of the above (B6), and they were reacted in a nitrogen atmosphere at 100°C for 1 hour to make a prepolymer having a residual isocyanate group.

Also, 33.6 parts by mass of the above prepolymer, 53.1 parts by mass of the above (B5), 122.3 parts by mass of the above (B7), 11.0 parts by mass of isocyanurate type polyisocyanate of hexamethylene diisocyanate B8 (manufactured by Sumitomo Bayer Urethane Co., Ltd., the trade name "Sumidur N3300"), and 0.29 parts by mass of the above (C1), as a polyisocyanate component, were mixed, and then, the butyl acetate was removed by heating at reduced pressure to make a polyisocyanate component $P_B$ liquid.

73.5 parts by mass of the above A liquid and 220.3 parts by mass of the above $P_B$ liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

(Example 10)

For a polyol component, 12.3 parts by mass of the above (A3) was added to 12.1 parts by mass of the above (A1), and they were heated and stirred to provide a uniform polyol component A liquid.

Also, 8.0 parts by mass of the above (B5), 15.0 parts by mass of 1,3-bis(isocyanatomethyl)cyclohexane B4 (manufactured by Mitsui Chemicals Polyurethanes, Inc., the trade name "TAKENATE T600"), 55.1 parts by mass of the above (B7), and 0.10 parts by mass of the above (C1), as a polyisocyanate component, were mixed, and then, the butyl acetate was removed by heating at reduced pressure to make a polyisocyanate component B liquid.

24.4 parts by mass of the above A liquid and 61.7 parts by mass of the above B liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

(Comparative Example 4)

15.2 parts by mass of the above (A1) as a polyol component A liquid, and 15.0 parts by mass of the above (B5) and 0.03 parts by mass of the above (C1) as a polyisocyanate component B liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

(Comparative Example 5)

For a polyol component, 4.1 parts by mass of the above (A3) and 1.2 parts by mass of the above (A2) were added to 6.5 parts by mass of the above (A1), and they were heated and stirred to provide a uniform polyol component A liquid.

On the other hand, 0.46 parts by mass of the above (A3) was added to 10.0 parts by mass of the above (B6), and they were reacted in a nitrogen atmosphere at 100°C for 1 hour to make a prepolymer having a residual isocyanate group.

Also, 10.46 parts by mass of the above prepolymer, 9.6 parts by mass of the above (B5), and 0.03 parts by mass of the above (C1), as a polyisocyanate component, were mixed, and then, the butyl acetate was removed by heating at reduced pressure to make a polyisocyanate component $P_B$ liquid.

11.8 parts by mass of the above A liquid and 20.1 parts by mass of the above $P_B$ liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

(Comparative Example 6)

For a polyol component, 0.93 parts by mass of the above (A2) was added to 12.9 parts by mass of the above (A1), and they were stirred to provide a uniform polyol component A liquid.

Also, 5.0 parts by mass of the above (B6), 5.24 parts by mass of the above (B5), 13.6 parts by mass of the above (B7), and 0.04 parts by mass of the above (C1), as a polyisocyanate component, were mixed, and then, the butyl acetate was removed by heating at reduced pressure to make a polyisocyanate component B liquid.

13.8 parts by mass of the above A liquid and 19.8 parts by mass of the above B liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

(Comparative Example 7)

For a polyol component, 9.1 parts by mass of the above (A3) and 2.9 parts by mass of the above (A2) were added to 26.2 parts by mass of polycaprolactone triol A4 having a weight-average molecular weight of 550 and a hydroxyl group value of 300 mgKOH/g (manufactured by DAICEL CHEMICAL INDUSTRIES, LTD., the trade name "PLACCEL 305"), and they were heated and stirred to provide a uniform polyol component A liquid.

On the other hand, 1.5 parts by mass of the above (A3) was added to 15.3 parts by mass of the above (B6), and they were reacted in a nitrogen atmosphere at 100°C for 1 hour to make a prepolymer having a residual isocyanate group.

Also, 16.8 parts by mass of the above prepolymer, 16.0 parts by mass of the above (B5), 41.5 parts by mass of the above (B7), and 0.1 parts by mass of the above (C1), as a polyisocyanate component, were mixed, and then, the butyl acetate was removed by heating at reduced pressure to make a polyisocyanate component $P_B$ liquid.

38.2 parts by mass of the above A liquid and 62.0 parts by mass of the above $P_B$ liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

(Comparative Example 8)

For a polyol component, 10.7 parts by mass of a propylene oxide adduct of trimethylolpropane A5 having a weight-average molecular weight of 400 and a hydroxyl group value of 400 mgKOH/g (manufactured by ADEKA CORPORATION, the trade name "T-400") and 2.9 parts by mass of the above (A2) were added to 4.9 parts by mass of the above (A1), and they were heated and stirred to provide a uniform polyol component A liquid.

Also, 5.0 parts by mass of the above (B6), 5.2 parts by mass of the above (B5), 13.6 parts by mass of the above (B7), and 0.04 parts by mass of the above (C1), as a polyisocyanate component, were mixed, and then, the butyl acetate was removed by heating at reduced pressure to make a polyisocyanate component B liquid.

16.5 parts by mass of the above A liquid and 19.76 parts by mass of the B liquid were mixed (hydroxyl group equivalent/isocyanate group equivalent ratio = 1.0), and the mixture was defoamed at reduced pressure. Then, a 3 mm thick cured product and a surface-mount LED package were made as in Example 7.

The amount of the A liquid, the B liquid, and the $P_B$ liquid compounded, in Examples and Comparative Examples, is shown in Tables 3 and 4. The amounts in the tables are all parts by mass.

[Table 3]

| Item | | | Example 7 | | Example 8 | | Example 9 | | Example 10 | |
|---|---|---|---|---|---|---|---|---|---|---|
| | | | A liquid | P$_B$ liquid | A liquid | P$_B$ liquid | A liquid | P$_B$ liquid | A liquid | B liquid |
| Polyol | Polycaprolactone polyol | A1 | 7.8 | - | 5.7 | - | 32.2 | - | 12.1 | - |
| | | A4 | - | - | - | - | - | - | - | - |
| | Aliphatic polyol | A3 | 5.0 | 0.56 | 5.9 | 0.65 | 32.9 | 3.6 | 11.1 | 1.2 |
| | | A5 | - | - | - | - | - | - | - | - |
| | Other polyol | A2 | 1.5 | - | 1.5 | - | 8.4 | - | - | - |
| Alicyclic isocyanate | Secondary isocyanate | B6 | - | 8.0 | - | 8.0 | - | 30.0 | - | - |
| | Primary isocyanate | B5 | - | 8.4 | - | 8.4 | - | 53.07 | - | 8.0 |
| | | B4 | - | - | - | - | - | - | - | 15.0 |
| | Isocyanurate type | B7 | - | 21.7 | - | 21.7 | - | 122.3 | - | 55.1 |
| | | B8 | - | - | - | - | - | 11.0 | - | - |
| Antioxidant | | C1 | - | 0.05 | - | 0.05 | - | 0.29 | - | 0.10 |

[Table 4]

| Item | | | Comp. Ex. 4 | | Comp. Ex. 5 | | Comp. Ex. 6 | | Comp. Ex. 7 | | Comp. Ex. 8 | |
|---|---|---|---|---|---|---|---|---|---|---|---|---|
| | | | A liquid | B liquid | A liquid | Pa liquid | A liquid | B liquid | A liquid | Pa liquid | A liquid | B liquid |
| Polyol | Polycaprolactone polyol | A1 | 15.2 | - | 6.5 | - | 12.9 | - | - | - | 4.9 | - |
| | | A4 | - | - | - | - | - | - | 26.2 | - | - | - |
| | Aliphatic polyol | A3 | - | - | 4.1 | 0.46 | - | - | 9.1 | 1.5 | - | - |
| | | A5 | - | - | - | - | - | - | - | - | 10.7 | - |
| | Other polyol | A2 | - | - | 1.2 | - | 0.93 | - | 2.9 | - | 0.9 | - |
| Alicyclic isocyanate | Secondary isocyanate | B6 | - | - | - | 10.0 | - | 5.0 | - | 15.3 | - | 5.0 |
| | Primary isocyanate | B5 | - | 15.0 | - | 9.6 | - | 5.24 | - | 16.0 | - | 5.2 |
| | | B4 | - | - | - | - | - | - | - | - | - | - |
| | Isocyanurate type | B7 | - | - | - | - | - | 13.6 | - | 41.5 - | - | 13.6 |
| | | B8 | - | - | - | - | - | - | - | - | - | - |
| Antioxidant | | C1 | - | 0.03 | - | 0.03 | - | 0.04 | - | 0.10 | - | 0.04 |

In the above tables, A1 represents polycaprolactone triol having a weight-average molecular weight of 300 and a hydroxyl group value of 540 mgKOH/g, A4 represents polycaprolactone triol having a weight-average molecular weight of 550 and a hydroxyl group value of 300 mgKOH/g, A3 represents trimethylolpropane, A5 represents a propylene oxide adduct of trimethylolpropane having a weight-average molecular weight of 400 and a hydroxyl group value of 400 mgKOH/g, A2 represents polycarbonate diol having a weight-average molecular weight of 500 and a hydroxyl group value of 230 mgKOH/g, B6 represents 4,4'-methylenebis(cyclohexyl isocyanate), B5 represents 2,5-(2,6)bisisocyanatomethyl[2,2,1]heptane, B4 represents 1,3-bis(isocyanatomethyl)cyclohexane, B7 represents a butyl acetate solution of 70% by mass of isocyanurate type isocyanate, which is a trimer of isophorone diisocyanate, B8 represents isocyanurate type polyisocyanate of hexamethylene diisocyanate, and C1 represents 3,9-bis [2-{3-(3-tert-butyl-4-hydroxy-5-methylphenyl)propionyl}-1,1-di methylethyl]-2,4,8,1,10-tetraoxaspiro[5,5]undecane.

The glass transition temperature, thermal expansion coefficient, and flexural modulus of the cured product of the resin obtained in Examples and Comparative Examples were measured by methods shown below. Also, the gelation time at 165°C, and the moldability in liquid transfer molding were evaluated. Further, a temperature cycle test and a high-temperature and high-humidity lighting test were performed on the surface-mount LED packages by methods shown below. The results of these are shown in Tables 5 and 6.

[Glass Transition Temperature and Thermal Expansion Coefficient]

A test piece, 19 mm × 3 mm and 3 mm thick, was cut, and measurement was performed by a thermomechanical analysis apparatus (the trade name "TMA-8141BS TAS-100," manufactured by Rikagaku Denki) at a temperature rising speed or 5°C/min. The glass transition temperature (hereinafter referred to as "Tg") was obtained from the bending point of the thermal expansion curve. A thermal expansion coefficient $\alpha_1$ was obtained from a slope in the range of Tg or less, and $\alpha_2$ was obtained from a slope in the range of Tg or more.

[Flexural Modulus]

A test piece, 20 mm × 50 mm and 3 mm thick, was cut. A bending test with three-point support was performed according to JIS-K-6911 using a three-point bending test apparatus (manufactured by Instron, model 5548), and the flexural modulus was calculated from the following formula. The distance between supporting points was 24 mm, the crosshead moving speed was 0.5 mm/min., and the measurement temperature was room temperature (25°C).

$$[\text{Expression 1}]$$

$$Ef = \frac{Lv^3}{4\,W\,h^3}\frac{\Delta P}{\Delta Y}$$

[wherein, Ef: flexural modulus (MPa), ΔY: displacement (mm), ΔP: load (N), Lv: distance between supporting points, W: the width of the test piece, and h: the thickness of the test piece.]

[Gelation Time]

For the gelation time, a gelation tester (manufactured by SYSTEM SEIKO) was used, the temperature of the hot plate was set to 165°C, and the time of the gelation of the resin solution was measured.

[Liquid Transfer Moldability Test]

The molding conditions of the liquid transfer molding were die temperature: 165 to 175°C, injection pressure: 4 MPa to 15 MPa, injection time: 20 to 50 seconds, and holding time: 180 to 300 seconds. The LED package shown in Figure 1, with outer dimensions of 5.1 mm × 3.9 mm × 4.7 mm, was made by the molding. The appearance of the made LED package was observed with a microscope. A case where voids and unfilled portions were not observed was evaluated as "A," and a case where at least one of voids or unfilled portions were observed was evaluated as "C."

[Temperature Cycle Test]

In the temperature cycle test, a sample was used which was obtained by casting the resin solution into the cavity part of a package in which a blue LED device was mounted in a case made of polyphthalamide and having outer dimensions of 3.2 mm × 2.6 mm × 1.8 mm and a cavity inner diameter of 2.4 mm(φ), and heating and curing the resin solution to make a surface-mount LED package.

For the test conditions, one cycle was -40°C for 0.5 hour and 85°C for 0.5 hour, and this was performed for 500 cycles. After the test, the sample was observed for the breaking of the wire, the detachment of the resin from the case material, the chip, and the like, cracks in the resin, and the like, using a microscope. The number of the samples was 10, and a case where any of the breaking of the wire, detachment, or cracks was observed in even one sample was "C," and a case where no such defects were observed was "A."

[High-Temperature and High-Humidity Lighting Test]

First, a DC 20 mA current was flowed through the above surface-mount LED package to light the LED. Luminance L1 at this time was measured using an instantaneous multiphotometer (manufactured by Otsuka Electronics Co., Ltd.). Then, the LED package was located in a constant temperature and humidity vessel at 85°C and 85% RH, and a DC 20 mA current was flowed through the LED package to maintain the LED in a lighted state for 1000 hours. Then, the LED package was removed from the constant temperature and humidity vessel, a DC 20 mA current was flowed to light the LED, and luminance L2 was measured. The ratio of luminance before and after the LED package was located in the constant temperature and humidity vessel (L2/L1) was a "luminance maintenance rate." A case where this luminance maintenance rate was 0.8 or more was evaluated as "A," a case where this luminance maintenance rate was 0.7 or more and less than 0.8 was evaluated as "B," and a case where this luminance maintenance rate was less than 0.7 was evaluated as "C."

[Table 5]

| Item | Example 7 | Example 8 | Examples 9 | Example 10 |
|---|---|---|---|---|
| Glass transition temperature (°C) | 131 | 131 | 131 | 132 |
| $\alpha1$ ($\times10^{-5}$/°C) | 7.6 | 7.2 | 7.9 | 7.2 |
| $\alpha2$ ($\times10^{-5}$/°C) | 18.1 | 17.6 | 18.9 | 17.9 |
| Flexural modulus (MPa) | 2210 | 2200 | 2210 | 2130 |
| Gelation time (sec.) | 150 | 170 | 150 | 120 |
| Liquid transfer moldability test | A | A | A | A |
| Temperature cycle test | A | A | A | A |
| High-temperature and high-humidity lighting test | A | A | A | A |

[Table 6]

| Item | Comp. Ex. 4 | Comp. Ex. 5 | Comp. Ex. 6 | Comp. Ex. 7 | Comp. Ex. 8 |
|---|---|---|---|---|---|
| Glass transition temperature (°C) | 60 | 107 | 103 | 96 | 80 |
| $\alpha1$ ($\times10^{-5}$/°C) | 7.0 | 8.6 | 8.3 | 9.4 | 11.0 |
| $\alpha2$ ($\times10^{-5}$/°C) | 18.4 | 20.5 | 19.3 | 19.3 | 20.4 |
| Flexural modulus (MPa) | 2100 | 1990 | 1930 | 1800 | 1900 |
| Gelation time (sec.) | 95 | 130 | 190 | 260 | 720 |
| Liquid transfer moldability test | A | A | A | C | C |
| Temperature cycle test | C | C | C | C | C |

(continued)

| Item | Comp. Ex. 4 | Comp. Ex. 5 | Comp. Ex. 6 | Comp. Ex. 7 | Comp. Ex. 8 |
|---|---|---|---|---|---|
| High-temperature and high-humidity lighting test | C | A | A | A | A |

As shown in Table 5, in any or Examples 7 to 10, the glass transition temperature was 110°C or more, $\alpha1$ was $10\times10^{-5}$/°C or less, $\alpha2$ was $20\times10^{-5}$/°C or less, and defects, such as the breaking of the wire and detachment, in the temperature cycle test were not seen, and therefore, it was clear that the temperature cycle resistance was excellent. Also, in any of Examples 7 to 10, a large decrease in luminance and defects, such as detachment, in the high-temperature and high-humidity lighting test were not seen, and therefore, it was clear that the high-temperature and high-humidity resistance was also excellent.

On the other hand, as shown in Table 6, in Comparative Example 4 having low glass transition temperature and comprising no polyisocyanate having an isocyanate group bonded to secondary carbon, the breaking of the wire occurred in the temperature cycle test, and the decrease in luminance was large in the high-temperature and high-humidity lighting test. Similarly, in any of Comparative Example 5 to 8, the glass transition temperature was low, and therefore, the breaking of the wire occurred.

**Industrial Applicability**

As described above, the present invention can provide a curable resin composition that can form a cured product particularly having sufficiently excellent high-temperature and high-humidity resistance, an LED package made using the resin composition, and a method for production of the LED package. Also, the present invention can provide a curable resin composition that can form a cured product having high transparency, excellent optical properties, such as heat and light discoloration resistance, and excellent mechanical properties, and simultaneously having high glass transition temperature and a low thermal expansion coefficient, and an optical semiconductor made using the curable resin composition.

**Claims**

1.   A curable resin composition comprising:

a polyol component containing tri- or higher functional polycaprolactone polyol; and
a polyisocyanate component containing 40% by mass or more of bifunctional or trifunctional alicyclic isocyanate having one or more chemical structures in which an isocyanate group is bonded to a secondary carbon atom.

2.   A curable resin composition comprising:

a polyol component containing 40% by mass or more of tri- or higher functional polycaprolactone polyol having a weight-average molecular weight of 800 or less and a hydroxyl group value of 200 mgKOH/g or more; and
a polyisocyanate component containing bifunctional or trifunctional alicyclic isocyanate having one or more chemical structures in which an isocyanate group is bonded to a secondary carbon atom.

3.   The curable resin composition according to Claim 1 or 2, wherein gelation time at 165°C is 10 to 200 seconds.

4.   The curable resin composition according to any one of Claims 1 to 3, wherein the polyol component contains a prepolymer having a residual hydroxyl group obtained by reacting polyol and bi- or higher functional isocyanate having a total number of isocyanate groups smaller than the total number of hydroxyl groups of the polyol.

5.   The curable resin composition according to any one of Claims 1 to 4, wherein the polyisocyanate component contains a prepolymer having a residual isocyanate group obtained by reacting bi- or higher functional isocyanate and polyol having a total number of hydroxyl groups smaller than the total number of isocyanate groups of the isocyanate.

6.   The curable resin composition according to any one of Claims 1 to 5, containing a hindered phenolic antioxidant.

7.   A light emitting diode package comprising a sealing member obtained by curing and molding a curable resin composition according to any one of Claims 1 to 6.

8. A method for production of a light emitting diode package comprising the step of curing and molding a curable resin composition according to any one of Claims 1 to 6 by liquid transfer molding to obtain a sealing member.

9. A curable resin composition comprising:

a polyol component; and
a polyisocyanate component containing bi- or higher functional isocyanurate type isocyanate having one or more chemical structures in which an isocyanate group is bonded to a secondary carbon atom,

wherein a cured product of the curable resin composition has a glass transition temperature of 110°C or more, a thermal expansion coefficient of $10.0 \times 10^{-5}$/°C or less at the glass transition temperature or lower, a thermal expansion coefficient of $20.0 \times 10^{-5}$/°C or less at the glass transition temperature or higher, and a flexural modulus of 1500 MPa or more at 25°C.

10. The curable resin composition according to Claim 9, wherein the polyol component contains 40% by mass or more of tri- or higher functional polycaprolactone polyol having a weight-average molecular weight of 500 or less and a hydroxyl group value of 300 mgKOH/g or more, and 30% by mass or more of tri- or higher functional aliphatic polyol having a weight-average molecular weight of 350 or less and a hydroxyl group value of 500 mgKOH/g or more, and wherein the polyisocyanate component contains 40% by mass or more of the isocyanurate type isocyanate.

11. The curable resin composition according to Claim 10, wherein the aliphatic polyol is trimethylolpropane or a derivative thereof.

12. The curable resin composition according to any one of Claims 9 to 11, wherein the isocyanurate type isocyanate is a trimer of isophorone diisocyanate.

13. The curable resin composition according to any one of Claims 9 to 12, wherein the polyol component contains a prepolymer having a residual hydroxyl group obtained by reacting polyol and bi- or higher functional isocyanate having a total number of isocyanate groups smaller than the total number of hydroxyl groups of the polyol.

14. The curable resin composition according to Claim 13, wherein the prepolymer in the polyol component is obtained by reacting the polyol and the isocyanate at a ratio of a hydroxyl group equivalent X in the polyol to an isocyanate group equivalent Y in the isocyanate (X/Y) of 3 or more.

15. The curable resin composition according to any one of Claims 9 to 14, wherein the polyisocyanate component contains a prepolymer having a residual isocyanate group obtained by reacting bi- or higher functional isocyanate and polyol having a total number of hydroxyl groups smaller than the total number of isocyanate groups of the isocyanate.

16. The curable resin composition according to Claim 15, wherein the polyol is tri- or higher functional aliphatic polyol having a weight-average molecular weight of 350 or less and a hydroxyl group value of 500 mgKOH/g or more.

17. The curable resin composition according to Claim 15 or 16, wherein the prepolymer in the polyisocyanate component is obtained by reacting the polyol and the isocyanate at a ratio of the hydroxyl group equivalent X in the polyol to the isocyanate group equivalent Y in the isocyanate (X/Y) of 0.05 to 0.30.

18. The curable resin composition according to any one of Claims 9 to 17, containing a hindered phenolic antioxidant.

19. The curable resin composition according to Claim 18, wherein the hindered phenolic antioxidant is 3,9-bis[2-{3-{3-t-butyl-4-hydroxy-5-methylphenyl)propianyl}-1,1-dime thylethyl]-2,4,8,10-tetraoxaspiro[5,5]undecane.

20. The curable resin composition according to any one of Claims 9 to 19, wherein gelation time at 165°C is 10 to 200 seconds.

21. The curable resin composition according to any one of Claims 9 to 20, containing the polyol component and the polyisocyanate component so that the ratio of a hydroxyl group equivalent in the polyol component to an isocyanate group equivalent in the polyisocyanate component (hydroxyl group equivalent/isocyanate group equivalent) is 0.7 to 1.3.

**22.** An optical semiconductor comprising a member obtained by molding a curable resin composition according to any one of Claims 9 to 21 by liquid transfer molding.

## Fig.1

*Fig.2*

## INTERNATIONAL SEARCH REPORT

| | International application No. |
|---|---|
| | PCT/JP2008/057840 |

A. CLASSIFICATION OF SUBJECT MATTER
*C08G18/42*(2006.01)i, *B29C45/02*(2006.01)i, *B29C45/14*(2006.01)i, *C08G18/10*(2006.01)i, *C08K5/13*(2006.01)i, *C08L75/04*(2006.01)i, *H01L33/00*(2006.01)i, *B29K101/10*(2006.01)n

According to International Patent Classification (IPC) or to both national classification and IPC

B. FIELDS SEARCHED

Minimum documentation searched (classification system followed by classification symbols)
C08G18/42, B29C45/02, B29C45/14, C08G18/10, C08K5/13, C08L75/04, H01L33/00, B29K101/10

Documentation searched other than minimum documentation to the extent that such documents are included in the fields searched
Jitsuyo Shinan Koho           1922-1996    Jitsuyo Shinan Toroku Koho   1996-2008
Kokai Jitsuyo Shinan Koho     1971-2008    Toroku Jitsuyo Shinan Koho   1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | WO 2007/049722 A1 (Hitachi Chemical Co., Ltd.), 03 May, 2007 (03.05.07), Claims; examples (Family: none) | 1,3-8 |
| X | JP 2001-278941 A (Mitsui Chemicals, Inc.), 10 October, 2001 (10.10.01), Claims; Par. Nos. [0003], [0043] to [0044], [0063], [0080], [0092], [0096], [0116] & US 2003/036620 A1      & EP 1167416 A1 & WO 01/053374 A1         & TW 572925 B & CN 1365370 A | 1,3-8 |
| Y | | 1,3-8 |
| Y | JP 2004-277498 A (Asahi Kasei Chemicals Corp.), 07 October, 2004 (07.10.04), Claims; Par. No. [0009]; examples (Family: none) | 1,3-8 |

☐ Further documents are listed in the continuation of Box C.     ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 12 May, 2008 (12.05.08) | 15 July, 2008 (15.07.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

## INTERNATIONAL SEARCH REPORT

| | International application No. |
|---|---|
| | PCT/JP2008/057840 |

**Box No. II     Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III     Observations where unity of invention is lacking (Continuation of item 3 of first sheet)**

This International Searching Authority found multiple inventions in this international application, as follows:
   See extra sheet.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
   1, and parts of 3-8 which relate to 1.

**Remark on Protest**     ☐ The additional search fees were accompanied by the applicant's protest and, where applicable,
the          payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

| **INTERNATIONAL SEARCH REPORT** | International application No. |
|---|---|
| | PCT/JP2008/057840 |

<u>Continuation of Box No.III of continuation of first sheet(2)</u>

The inventions of claims 1 and 2 of the present application relate to a curable resin composition, and share such a common matter that the resin composition comprises: a component which comprises a polycaprolactonepolyol having the number of functionality of 3 or greater; and a component which comprises a bifunctional or trifunctional alicyclic isocyanate having at least one chemical structure composed of an isocyanate group bound to a secondary carbon atom. However, the common matter is known from JP 61-28518 A and JP 61-12759 A, and therefore cannot be regarded as a "special technical feature" (i.e., those technical features that define a contribution which each of the inventions claimed in claims, considered as a whole, makes over the prior art) in the meaning within PCT Rule 13.2 (see Example 8 in JP 61-28518 A, and example 8 in JP 61-12759 A; "PLACEL 305" (a name of a product from Daicel Chemical Industries, Ltd.) shown as a polycaprolactonepolyol is a trifunctional compound, see Table 1 in each of the documents).

Further, the inventions of claims 1 or 2 and 9 of the present application relate to a curable resin composition, and share such a common matter that the resin composition comprises a polyol component and a bifunctional or trifunctional isocyanate component having at least one chemical structure composed of an isocyanate group bound to a secondary carbon atom. However, the common matter cannot also be regarded as a "special technical feature" (i.e., those technical features that define a contribution which each of the inventions claimed in claims, considered as a whole, makes over the prior art) in the meaning within PCT Rule 13.2 for the same reason as stated above.

Therefore, the present application is composed of the following groups of inventions.

1$^{st}$ invention: the invention of claim 1 and the inventions of parts of claims 3-8 which relate to claim 1.
2$^{nd}$ invention: the invention of claim 2 and the inventions of parts of claims 3-8 which relate to claim 2.
3$^{rd}$ invention: the inventions of claims 9-22.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003171439 A
- JP 2004075894 A
- JP 2004186168 A
- JP 2003301025 A
- JP 2001278941 A